# EUROPEAN PATENT APPLICATION

(11) **EP 4 746 662 A1**
(43) Date of publication of application: **20.05.2026**
(21) Application number: 24839700.2
(22) Date of filing: 08.07.2024
(51) Int. Cl.: H10K 85/10, C08G 73/02, H10K 50/15, H10K 50/17, H10K 50/18, H10K 59/10

(54) **ORGANIC ELECTRONICS MATERIAL, ORGANIC LAYER, AND ORGANIC ELECTRONICS ELEMENT**

(30) Priority: 10.07.2023 JP 2023113252
(71) Applicant: Resonac Corporation, Tokyo 105-7325 (JP)
(72) Inventor: FUKUSHIMA Iori, Tokyo 105-7325 (JP); KAMO Kazuyuki, Tokyo 105-7325 (JP); MIYA Takanori, Tokyo 105-7325 (JP)
(74) Representative: Hoffmann Eitle
(86) International application number: PCT/JP2024/024527
(87) International publication number: WO 2025/013808

(57) **Abstract**

An organic electronics material includes a charge transport polymer which has a branched structure, includes a trivalent structural unit represented by formula (a) below, and a divalent structural unit represented by formula (b) below, has a structure represented by formula (I) and is formed through a direct bonding of at least one bonding site in the trivalent structural unit and at least one bonding site in the divalent structural unit, and has a weight average molecular weight of 2,000 to 500,000. In the formulas, Ar' represents a trivalent organic group derived from an aromatic hydrocarbon or aromatic heterocycle of 2 to 30 carbon atoms, or triarylamine, Ar² represents a monovalent organic group derived from an aromatic hydrocarbon of 6 to 30 carbon atoms which has an electron-withdrawing group or an electron-donating group, and * represents a bonding site with another structure.

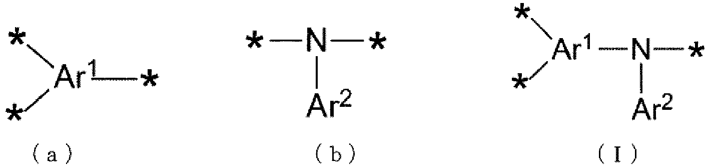

## Description

### TECHNICAL FIELD

Embodiments of the present invention relate to an organic electronics material, an organic layer, and an organic electronics element.

### BACKGROUND ART

Organic electronics elements are elements that use an organic material to perform an electrical operation, and because they are expected to be capable of providing advantages such as low energy consumption, low prices and superior flexibility, they are attracting considerable attention as a potential alternative technology to conventional inorganic semiconductors containing mainly silicon.

Examples of organic electronics elements include organic electroluminescence elements (hereinafter referred to as organic EL elements), organic photoelectric conversion elements, and organic transistors. Among organic electronics elements, organic EL elements are attracting attention for potential use in large-surface area solid state lighting applications to replace incandescent lamps, gas-filled lamps, and the like. Further, organic EL elements are also attracting attention as the leading self-luminous display for replacing liquid crystal displays (LCDs) in the field of flat panel displays (FPDs), and commercial products are becoming increasingly available.

Organic EL elements are roughly classified into small molecule organic EL elements and polymer organic EL elements according to organic materials configuring elements. Small molecule organic EL elements use small molecular compounds, and require a dry process for film formation under vacuum. In contrast, polymer organic EL elements use polymer compounds, and enable simple film formation through wet processes such as plate-based printing such as relief printing and intaglio printing, and plateless printing such as inkjet printing.

Accordingly, polymer organic EL elements capable of simple film formation are expected to be indispensable for realizing large-screen organic EL displays in the future. Therefore, in recent years, various charge transport polymers have been developed as polymer compounds configuring polymer organic EL elements.

### PRIOR ART DOCUMENTS

### PATENT DOCUMENT

Patent Document 1: WO 2008/010487

### SUMMARY OF THE INVENTION

### PROBLEMS TO BE SOLVED BY THE INVENTION

As an example of charge transport polymers, arylamine polymers are widely known, and improvement of properties of organic EL elements using molecular design of polymers is being studied. Patent Document 1 discloses an arylamine polymer including a triphenylamine structure.

However, in recent years, further improvement of properties such as conductivity has been required in the field of organic electronics such as organic EL elements, and conventional arylamine polymers have room for improvement. Furthermore, in order to introduce a specific structure into an arylamine polymer, expensive materials or multi-step processes are often required in production of the polymer. Thus, there is a need for a charge transport polymer which can form an organic layer capable of improving properties of organic EL elements, and which can be obtained with a simple method using inexpensive materials.

Accordingly, an embodiment of the present invention provides one organic electronics material including a charge transport polymer which can form an organic layer capable of improving conductivity, and which can be obtained with a simple method using an inexpensive material.

### MEANS TO SOLVE THE PROBLEMS

The inventors have intensively investigated charge transport polymers having an arylamine structure, and discovered that a polymer having a specific arylamine structure is suitable as an organic electronics material, thereby completing the present invention.

That is, although embodiments of the present invention relate to the following, the present invention is not limited to the following embodiments and includes various embodiments.

<1> An organic electronics material including a charge transport polymer having a branched structure wherein the charge transport polymer includes: a trivalent structural unit represented by formula (a) below; and a divalent structural unit represented by formula (b) below, the charge transport polymer includes a structure which is represented by formula (I) and is formed through direct bonding of at least one bonding site in the trivalent structural unit and at least one bonding site in the divalent structural unit, and the charge transport polymer has a weight average molecular weight of 2,000 to 500,000.

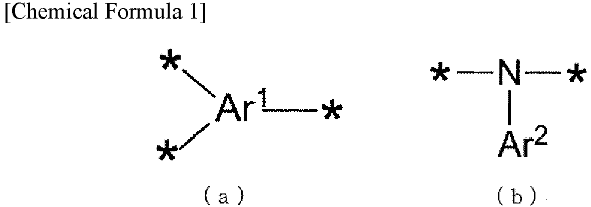

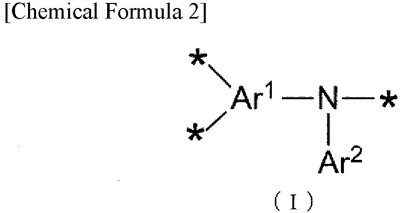

In the formulas, Ar¹ represents a trivalent organic group derived from an aromatic hydrocarbon or aromatic heterocycle of 2 to 30 carbon atoms, or triarylamine, Ar² represents a monovalent organic group derived from an aromatic hydrocarbon of 6 to 30 carbon atoms which has an electron-withdrawing group or an electron-donating group, and * represents a bonding site with another structure.

<2> The organic electronics material according to <1> above, wherein the structure represented by the formula (I) includes a structure represented by formula (I-1) below or formula (I-2) below.

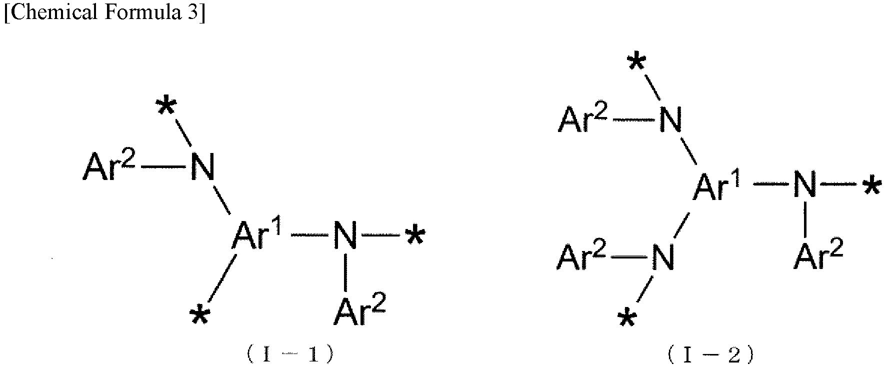

In the formulas, Ar' represents a trivalent organic group derived from an aromatic hydrocarbon or aromatic heterocycle of 2 to 30 carbon atoms, or triarylamine, Ar² represents a monovalent organic group derived from an aromatic hydrocarbon of 6 to 30 carbon atoms which has an electron-withdrawing group or an electron-donating group, and * represents a bonding site with another structure.

<3> The organic electronics material according to <1> or <2> above, wherein in the formula (I), Ar¹ has a structure derived from triphenylamine or a structure derived from N-phenylcarbazole.

<4> The organic electronics material according to any one of <1> to <3> above, wherein in the formula (I), Ar² has a structure represented by formula (b-1) below.

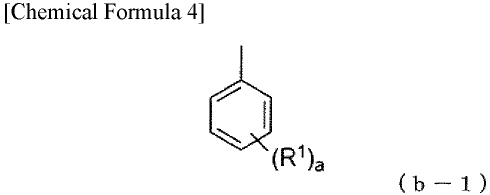

In the formula, R¹ is an electron-withdrawing group, an electron-donating group, or an alkyl group of 1 to 12 carbon atoms, where at least one R¹ is an electron-withdrawing group or an electron-donating group, and a is an integer from 1 to 5.

<5> The organic electronics material according to <5> above, wherein in the formula (b-1), R¹ is an electron-withdrawing group, a is an integer equal to 1 or 2, and the electron-withdrawing group is at least one selected from the group consisting of a halogen group, a halogen-substituted alkyl group, a nitro group, a cyano group, a sulfonic acid group, and a sulfoxide group.

<6> The organic electronics material according to any one of <1> to <5> above, wherein the charge transport polymer further includes a monovalent structural unit represented by formula (c) below.

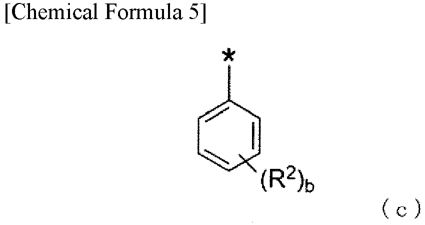

In the formula, R² is an alkyl group of 1 to 8 carbon atoms, and b is an integer from 1 to 5.

<7> The organic electronics material according to any one of <1> to <6> above, further including a solvent.

<8> An organic layer formed by using the organic electronics material according to any one of <1> to <7> above.

<9> An organic electronics element including the organic layer according to <8> above.

<10> An organic electroluminescence element including the organic layer according to <8> above.

The disclosure of the present application relates to the subject matter described in Japanese Patent Application No. 2023-113252 filed on July 10, 2023, the entire disclosed contents of which are incorporated herein by reference.

### EFFECTS OF THE INVENTION

According to one embodiment of the present invention, it is possible to provide an organic electronics material including a charge transport polymer that can form an organic layer capable of improving conductivity, and can be obtained with a simple method using an inexpensive material.

### BRIEF DESCRIPTION OF THE DRAWINGS

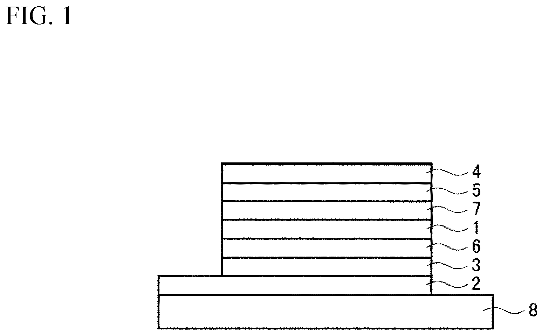

[FIG. 1] FIG. 1 is a cross-sectional schematic view illustrating one example of an organic EL element according to one embodiment of the present invention.

### EMBODIMENTS FOR CARRYING OUT THE INVENTION

Embodiments of the present invention will be described below, but the present invention is not limited to the following embodiments.

### <Organic electronics Material>

### (Charge Transport Polymer)

An embodiment relates to an organic electronics material, and a charge transport polymer configuring the organic electronics material may have at least a branched structure represented by formula (I) below, and may have an electron-withdrawing group or an electron-donating group at a predetermined position. The electron-withdrawing group or the electron-donating group is introduced as a substituent to an aromatic ring of Ar² as described below.

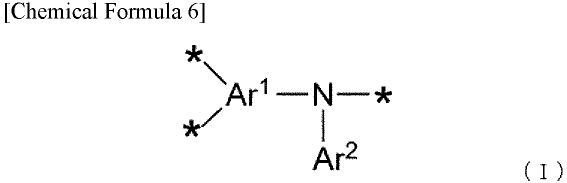

More specifically, the charge transport polymer according to the present embodiment has charge transport properties, and includes at least a trivalent or higher structural unit B configuring a branched portion, and a divalent structural unit L. The charge transport polymer preferably further includes a monovalent structural unit T.

The charge transport polymer having a branched structure has excellent heat resistance and can introduce many terminal groups, and thus exhibits favorable solubility and curability. The charge transport polymer may have only one type of each structural unit, or multiple types of each structural unit. In the charge transport polymer, each structural unit is bonded to each other at "monovalent" to "trivalent or higher" bonding sites.

Examples of partial structures included in the charge transport polymer are described below. However, the charge transport polymer is not limited to polymers having the following partial structures. In the partial structures, "L" represents a structural unit L, "T" represents a structural unit T, and "B" represents a structural unit B. The symbol "*" represents a bonding site with another structural unit. In the following partial structures, multiple L units may be the same structural unit, or mutually different structural units. This also applies for the T and B units.

### (Partial Structure of Charge Transport Polymer with Branched Structure)

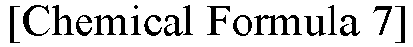

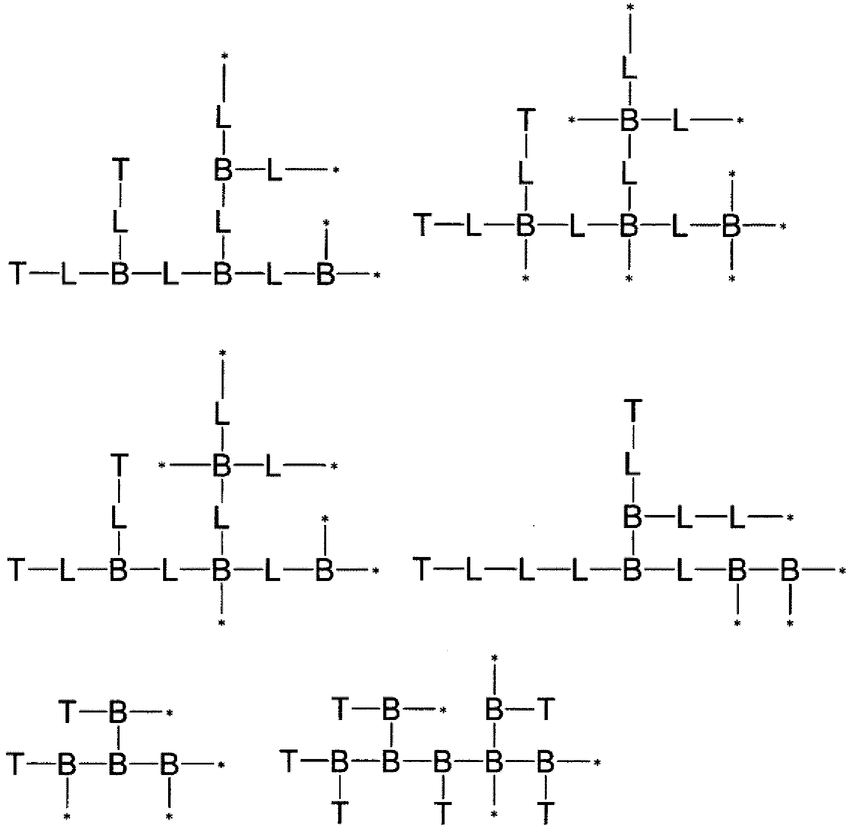

The charge transport polymer according to the present embodiment preferably includes at least a trivalent structural unit represented by formula (a) below as the structural unit B, and at least a divalent structural unit represented by formula (b) below as the structural unit L, and includes a structure represented by formula (I) below where at least one bonding site in each structural unit is directly bonded to one bonding group in another structural unit.

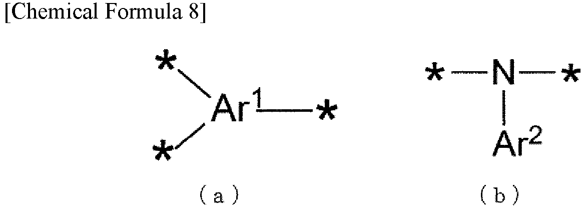

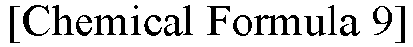

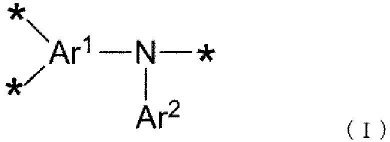

In the formulas, Ar¹ represents a trivalent organic group derived from an aromatic hydrocarbon or aromatic heterocycle of 2 to 30 carbon atoms, or triarylamine, Ar² represents a monovalent organic group derived from an aromatic hydrocarbon of 6 to 30 carbon atoms which has an electron-withdrawing group or an electron-donating group, and * represents a bonding site with another structure. Details of Ar¹ and Ar² will be described below.

The charge transport polymer preferably includes a structure represented by formula (I-1) below or formula (I-2) below, and more preferably includes a structure represented by formula (I-2) below. In each formula, Ar¹, Ar², and * are the same as those described above.

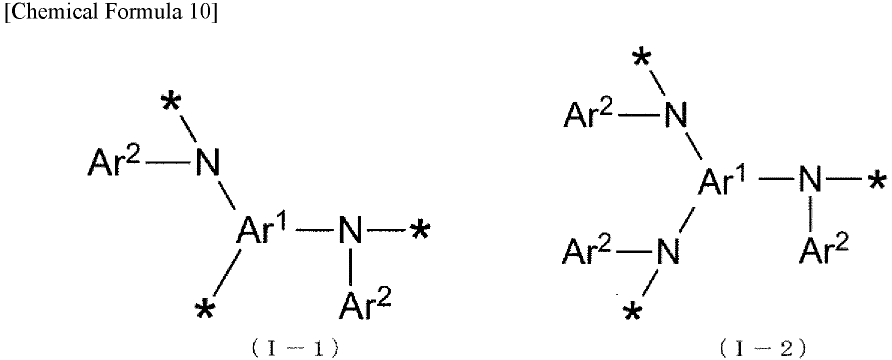

Hereinafter, structural units of the charge transport polymer will be described more specifically.

### (Structural Unit B)

The structural unit B is a trivalent or higher structural unit configuring a branched portion of the charge transport polymer having a branched structure. The structural unit B is preferably hexavalent or lower, more preferably trivalent or tetravalent, from the viewpoint of improving durability of an organic electronics element. The structural unit B preferably has charge transport properties. For example, the structural unit B may be an organic group derived from an aromatic hydrocarbon, an aromatic heterocycle, or a triarylamine. In particular, from the viewpoint of improving durability of an organic electronics element, for example, an organic group (structure) derived from a substituted or unsubstituted triarylamine, carbazole, or fused polycyclic aromatic hydrocarbon can be preferably selected as the structural unit B.

The charge transport polymer according to the present embodiment includes at least a trivalent structural unit (hereinafter also referred to as structural unit B1) represented by the above formula (a), as the structural unit B.

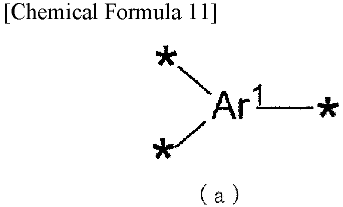

**In** the formula, Ar¹ represents a trivalent organic group derived from an aromatic hydrocarbon, an aromatic heterocycle, or a triarylamine. The trivalent organic group is also called an arenetriyl group or a heteroarenetriyl group. Ar¹ is an atomic group obtained by removing three hydrogen atoms from an aromatic ring in an aromatic hydrocarbon, aromatic heterocycle, or a triarylamine.

In one embodiment, Ar¹ may preferably be a trivalent organic group derived from an aromatic hydrocarbon or aromatic heterocycle of 2 to 30 carbon atoms.

Examples of the aromatic hydrocarbon include benzene, naphthalene, anthracene, tetracene, fluorene, phenanthrene, 9,10 dihydrophenanthrene, triphenylene, pyrene, chrysene, perylene, triphenylene, pentacene, and benzopyrene.

Examples of the aromatic heterocycle include pyridine, pyrazine, quinoline, isoquinoline, acridine, phenanthroline, carbazole, furan, benzofuran, dibenzofuran, pyrrole, thiophene, benzothiophene, dibenzothiophene, oxazole, oxadiazole, thiadiazole, triazole, benzoxazole, benzoxadiazole, benzothiadiazole, benzotriazole, and benzothiophene.

The aromatic hydrocarbon and aromatic heterocycle may be a monocyclic ring or a condensed ring. The aromatic hydrocarbon and aromatic heterocycle may have a polycyclic structure where two or more selected from a monocyclic ring and a condensed ring are bonded via a single bond. Examples of the aromatic hydrocarbon having the polycyclic structure include biphenyl, terphenyl, and triphenylbenzene.

In one embodiment, Ar¹ may be a trivalent organic group derived from a triarylamine. The triarylamine means a tertiary aromatic amine where three aryl groups (aromatic groups) are bonded to a nitrogen atom. Here, the aryl group is a monovalent organic group derived from an aromatic hydrocarbon or aromatic heterocycle of 2 to 30 carbon atoms. The aromatic hydrocarbon and the aromatic heterocycle may be specifically as described above. In the triarylamine, specific examples of the aryl group derived from the aromatic hydrocarbon group include a phenyl group, a naphthyl group, and a biphenyl group. Specific examples of the aryl group derived from the aromatic heterocyclic group include a thienyl group, a furyl group, a pyrrolyl group, a pyridyl group, and an imidazolyl group. In one embodiment, the triarylamine is preferably triphenylamine.

Each of the aromatic hydrocarbon and aromatic heterocycle included in the above monovalent and trivalent organic groups may be unsubstituted, or may have one or more substituents R. Each of the substituents R is independently selected from the group consisting of -R¹, -OR², -SR³, -OCOR⁴, - COOR⁵, -SiR⁶R⁷R⁸, a halogen atom, and a group including a polymerizable functional group as described below. In one embodiment, R is more preferably -R¹.

R¹ to R⁸ each independently represent: a hydrogen atom; a linear, branched, or cyclic alkyl group of 1 to 22 carbon atoms (except when R¹ becomes a hydrogen atom); or an aryl or heteroaryl group of 2 to 30 carbon atoms. The aryl group is an atomic group obtained by removing one hydrogen atom from an aromatic hydrocarbon. The heteroaryl group is an atomic group obtained by removing one hydrogen atom from an aromatic heterocycle. The alkyl group may be further substituted by an aryl group or heteroaryl group of 2 to 20 carbon atoms, and the aryl group or the heteroaryl group may be further substituted by a linear, branched, or cyclic alkyl group of 1 to 22 carbon atoms.

Specific examples of the structural unit B1 include the following structures. Among them, structures derived from triarylamines, and structures derived from N-arylcarbazoles are preferred.

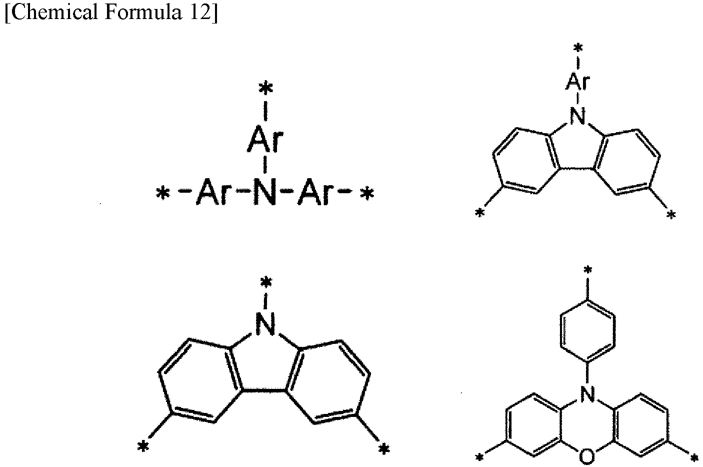

In the formula, Ar each independently represents a divalent linking group, for example, each independently represents an arylene group or heteroarylene group of 2 to 30 carbon atoms. Ar is preferably an arylene group, and more preferably a phenylene group.

In one embodiment, the structural unit B1 preferably includes at least one of a structural unit derived from a triphenylamine structure represented by formula (B 1-1) below, or a structural unit derived from an N-phenylcarbazole structure represented by formula (B1-2) below.

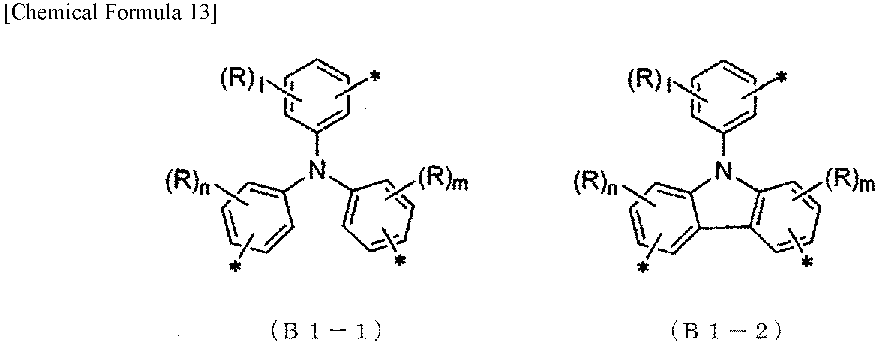

In the structural unit (B1-1), l, m, and n are each independently an integer from 0 to 4, and each represents the number of substituents R. 1, m, and n are each independently an integer from 0 to 2, and more preferably an integer equal to 0 or 1. In one embodiment, the number of substituents in the structural unit (B1-1) is preferably 1 or 2. In another embodiment, the number of substituents in the structural unit (B1-1) is preferably 0.

In the structural unit (B1-2), l is an integer from 0 to 4, and m and n are each independently an integer from 0 to 3, indicating the number of substituents R, respectively. l is preferably an integer from 0 to 2, and more preferably an integer equal to 0 or 1. m and n are each independently an integer from 0 to 2, and more preferably an integer equal to 0 or 1. In one embodiment, the number of substituents in the structural unit (B1-2) is preferably 1 or 2. In another embodiment, the number of substituents in the structural unit (B1-2) is preferably 0.

In each of the structural units, "*" indicates a bonding site with another structure, and at least one of bonding sites bonds to a nitrogen atom (N). In the structural unit (B1-1) or (B1-2), it is preferable that two or three of the three bonding sites each bond to a nitrogen atom. It is more preferable that all of the three bonding sites each bond to a nitrogen atom. When a charge transport polymer includes an N-Ph bond, doping and conjugation are facilitated, and it tends to be easier to obtain better conductivity. From this viewpoint, it is preferable that the structural unit B include any one of the structural unit (B1-1) derived from triphenylamine, and the structural unit (B1-2) derived from N-phenylcarbazole, described below. By including these structural units, it is easier to obtain better conductivity.

In the structural units (B1-1) and (B 1-2), the substituent R is the same as the substituent R described above for the structure represented by formula (I). In one embodiment, when the structural unit B has the structural unit (B1-1) or (B1-2), the substituent R may be a linear, branched, or cyclic alkyl group of 1 to 12 carbon atoms, or an aryl group of 6 to 12 carbon atoms. The aromatic ring in the aryl group may be further substituted with a linear, branched, or cyclic alkyl group of 1 to 12 carbon atoms. In another embodiment, both of the structural units (B1-1) and (B1-2) are preferably unsubstituted.

In one embodiment, the structural unit B may include a tetravalent or higher structural unit B2 in addition to the structural unit B1. For example, specific examples of the structural unit B2 include the following. Thereamong, a structure including a triarylamine structure, and a structure including a carbazole structure are preferred.

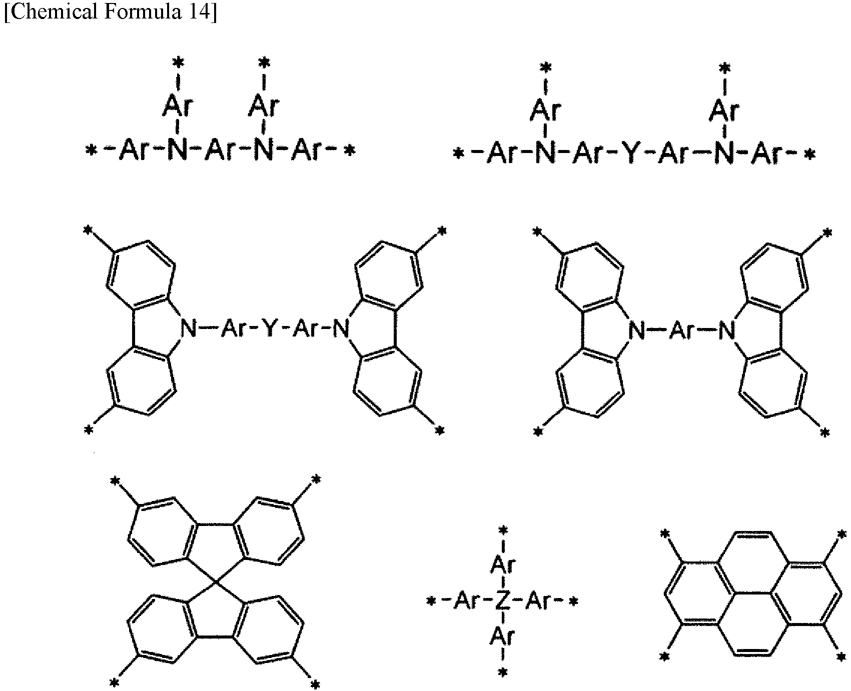

In the formulas, Ar independently represents an arylene group or heteroarylene group of 2 to 30 carbon atoms. Ar is preferably an arylene group, and more preferably a phenylene group. Y represents a divalent linking group, and an example thereof is a divalent group obtained by removing one additional hydrogen atom from a group having one or more hydrogen atoms among R (excluding groups including a polymerizable functional group) in a structural unit L describe below. Z represents any one of a carbon atom, a silicon atom, and a phosphorus atom. In the structural unit, the benzene ring and Ar may have a substituent, and an example of the substituent is the substituent R in the structural unit B1 described above.

### (Structural Unit L)

The structural unit L is a divalent structural unit having charge transport properties. There are no particular limitations on the structural unit L, as long as it includes an atomic group having charge transport ability. From the viewpoint of forming a structure represented by formula (I), by directly bonding to the structural unit (a) described above, the structural unit L includes at least a divalent structural unit represented by formula (b) below (hereinafter also referred to as structural unit L1).

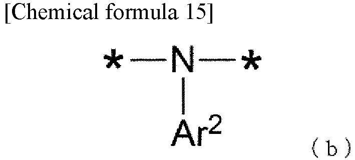

In the formula, Ar² is a monovalent organic group derived from an aromatic hydrocarbon of 6 to 30 carbon atoms which has an electron-withdrawing group or an electron-donating group, and is an atomic group obtained by removing one hydrogen atom from an aromatic ring in the aromatic hydrocarbon. That is, Ar² is also called an aryl group. Ar² is an aryl group of 6 to 30 ring-forming carbon atoms, and has a structure where at least one hydrogen atom of an aromatic ring in the aryl group is substituted with an electron-withdrawing group or an electron-donating group. For the above Ar², the number of ring-forming carbon atoms is more preferably 6 to 24.

Specific examples of the aromatic hydrocarbon include benzene, naphthalene, anthracene, tetracene, fluorene, phenanthrene, biphenyl, terphenyl, and triphenylbenzene. Here, the aromatic ring in the aromatic hydrocarbon may have an electron-withdrawing group or an electron-donating group as one or more substituents, and may further have another substituent as necessary.

In one embodiment, the above Ar² may have a structure represented by formula (b-1) below.

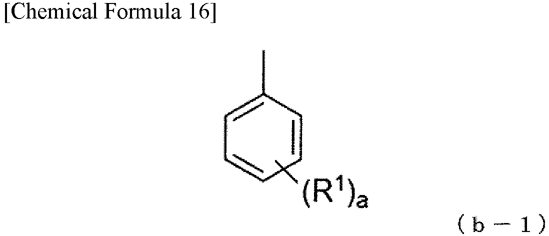

In the formula, R¹ is an electron-withdrawing group, an electron-donating group, or an alkyl group of 1 to 12 carbon atoms, a is an integer from 1 to 5, and at least one R¹ is an electron-withdrawing group, or an electron-donating group.

In one embodiment, a is preferably from 1 to 4, more preferably from 1 to 3, and even more preferably 1 or 2.

"Electron-withdrawing group" refers to a substituent that is more likely to attract an electron from a bonding atom side, compared with a hydrogen atom. "Electron-donating group" refers to a substituent that is more likely to donate an electron to a bonding atom side, compared with a hydrogen atom, and does not include an alkyl group. When the charge transport polymer includes a specific structure where a hydrogen atom in an aromatic ring bonded to an N atom is substituted with an electron-withdrawing group or an electron-donating group, a HOMO level tends to be easily adjusted.

For example, when an electron-withdrawing group is introduced into a specific portion of a charge transport polymer, as described above, the HOMO level can be deepened. In addition, when an electron-withdrawing group is introduced into a specific portion, solubility of the charge transport polymer tends to be improved. From this viewpoint, in one embodiment, in a charge transport polymer having a structure of formula (I), it is preferable that a hydrogen atom in an aromatic ring of Ar² be substituted with an electron-withdrawing group.

The electron-withdrawing group is not particularly limited, but specific examples include a halogen group, a halogen-substituted alkyl group, a nitro group, a cyano group, a sulfonic acid group, and a sulfoxide group. More specifically, examples of the halogen group include a fluoro group, a chloro group, a bromo group, and an iodine group. The number of carbon atoms of the alkyl group in a halogen-substituted alkyl group is preferably 1 to 6, more preferably 1 to 3, and even more preferably 1. From the viewpoint of electron-withdrawing strength, the halogen group is preferably a fluoro group, and the halogen-substituted alkyl group is preferably a fluoroalkyl group.

In consideration of thermal stability of a charge transport polymer, the electron-withdrawing group is preferably at least one selected from the group consisting of a fluoro group, a fluoroalkyl group, a nitro group, a cyano group, a sulfonic acid group, and a sulfoxide group. More preferably, the electron-withdrawing group may be at least one selected from the group consisting of a fluoro group, a fluoroalkyl group, a sulfonic acid group, and a sulfoxide group. Even more preferably, the electron-withdrawing group may be at least one of a fluoro group or a fluoroalkyl group. When an aryl group includes multiple electron-withdrawing groups, the multiple electron-withdrawing groups may be the same or different from each other.

In one embodiment, Ar² in formula (I) preferably has a structure represented by formula (b-1a) or (b-1b) below.

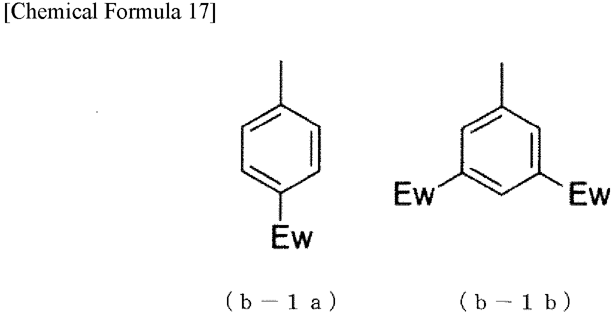

In each formula, Ew represents an electron-withdrawing group. In the structure represented by the above formula (b-1a) or (b-1b), the electron-withdrawing group (Ew) is preferably a halogen atom or a halogen-substituted alkyl group. Particularly, a fluorine atom (F) or trifluoromethane (CF₃) is more preferable.

The electron-donating group is not particularly limited, but specific examples thereof include - OR, -OH, and -NR₂. The alkyl group of the alkyloxy group (-OR) may have any one of a linear, branched, or cyclic structure. The number of carbon atoms of the alkyl group may preferably be 1 to 8, more preferably 1 to 6, and even more preferably 1 to 4.

In one embodiment, Ar² in formula (I) preferably has a structure represented by formula (b-1c) or (b-1d) below.

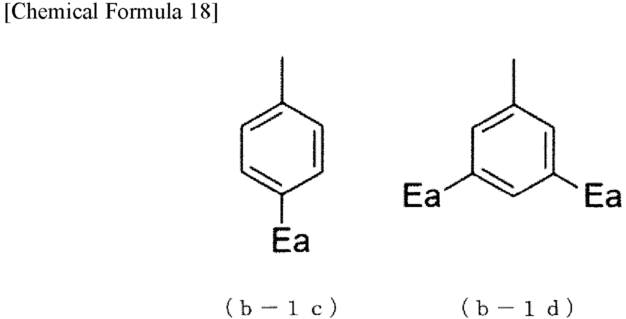

In each formula, Ea represents an electron-donating group. In the structure represented by the above formula (b-1c) or (b-1d), the electron-donating group (Ea) is preferably -OR, and a methoxy group is particularly preferable.

As described above, a charge transport polymer having a structure represented by the above formula (I) includes at least one electron-withdrawing group or electron-donating group, as a substituent for an aromatic ring in Ar². In one embodiment, a charge transport polymer may further have an alkyl group of 1 to 12 carbon atoms, in addition to at least one electron-withdrawing group or electron-donating group, as the substituent.

The alkyl group of 1 to 12 carbon atoms may have any one of a linear, branched, or cyclic structure. In one embodiment, the alkyl group preferably has a linear or branched structure. **In** one embodiment, in consideration of application to a wet process, from the viewpoint of solubility in a solvent, R¹ may preferably be an alkyl group of 2 to 12 carbon atoms, more preferably an alkyl group of 3 to 12 carbon atoms, and even more preferably an alkyl group of 4 to 12 carbon atoms.

In one embodiment, the structural unit L may further include, in addition to the structural unit L1, a structural unit L2 having a structure different from that of the structural unit L1. The structural unit L2 is selected from a substituted or unsubstituted triarylamine structure, carbazole structure, thiophene structure, a bithiophene structure, fluorene structure, benzene structure, biphenylene structure, terphenylene structure, naphthalene structure, anthracene structure, tetracene structure, phenanthrene structure, dihydrophenanthrene structure, pyridine structure, pyrazine structure, quinoline structure, isoquinoline structure, quinoxaline structure, acridine structure, diazaphenanthrene structure, furan structure, pyrrole structure, oxazole structure, oxadiazole structure, thiazole structure, thiadiazole structure, triazole structure, benzothiophene structure, benzoxazole structure, benzoxadiazole structure, benzothiazole structure, benzothiadiazole structure, benzotriazole structure, N-arylphenoxazine structure, and a structure including one or more of these structures. The triarylamine structure is more preferably a triphenylamine structure.

In one embodiment, from the viewpoint of obtaining superior hole transport properties, the structural unit L2 preferably includes one or more structures selected from the group consisting of a substituted or unsubstituted triarylamine structure, carbazole structure, thiophene structure, bithiophene structure, benzene structure, fluorene structure, and pyrrole structure, and more preferably includes one or more structures selected from the group consisting of a substituted or unsubstituted triarylamine structure and carbazole structure. In another embodiment, from the viewpoint of obtaining superior electron transport properties, the structural unit L preferably includes one or more structures selected from the group consisting of a substituted or unsubstituted fluorene structure, benzene structure, phenanthrene structure, pyridine structure, and quinoline structure.

Specific examples of the structural unit L2 include the following. However, the structural unit L2 is not limited to the following.

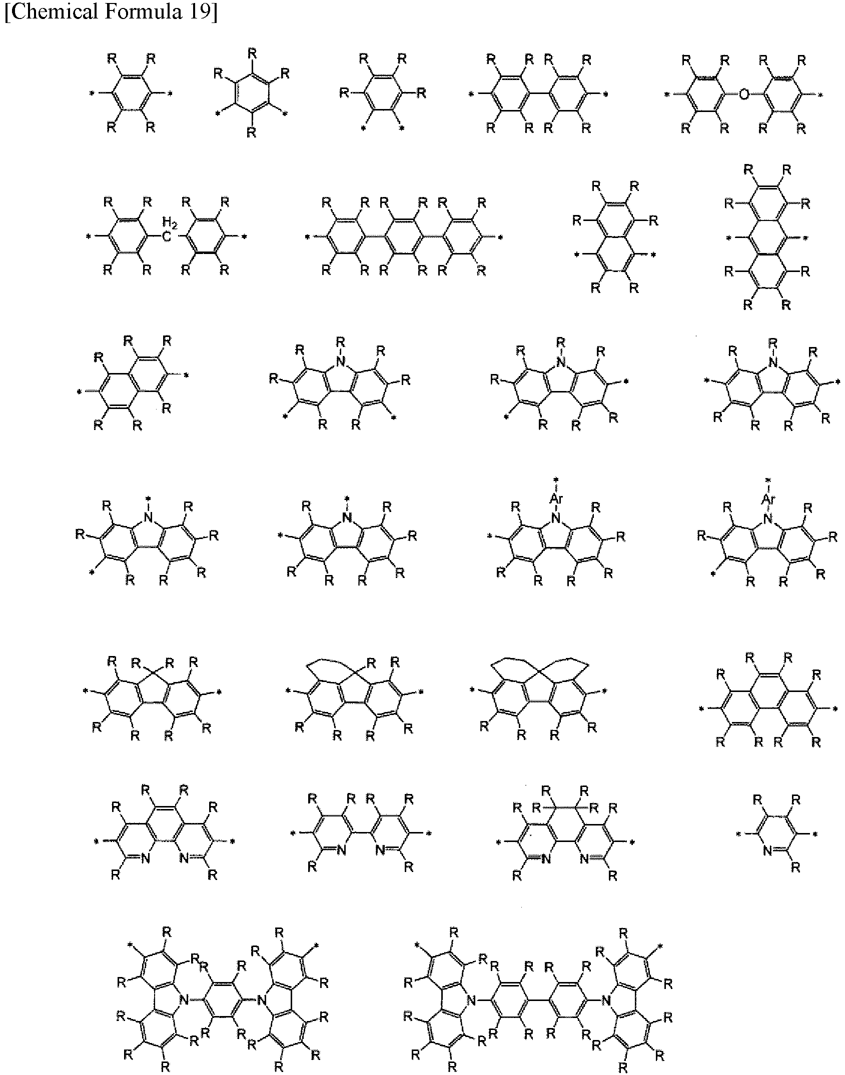

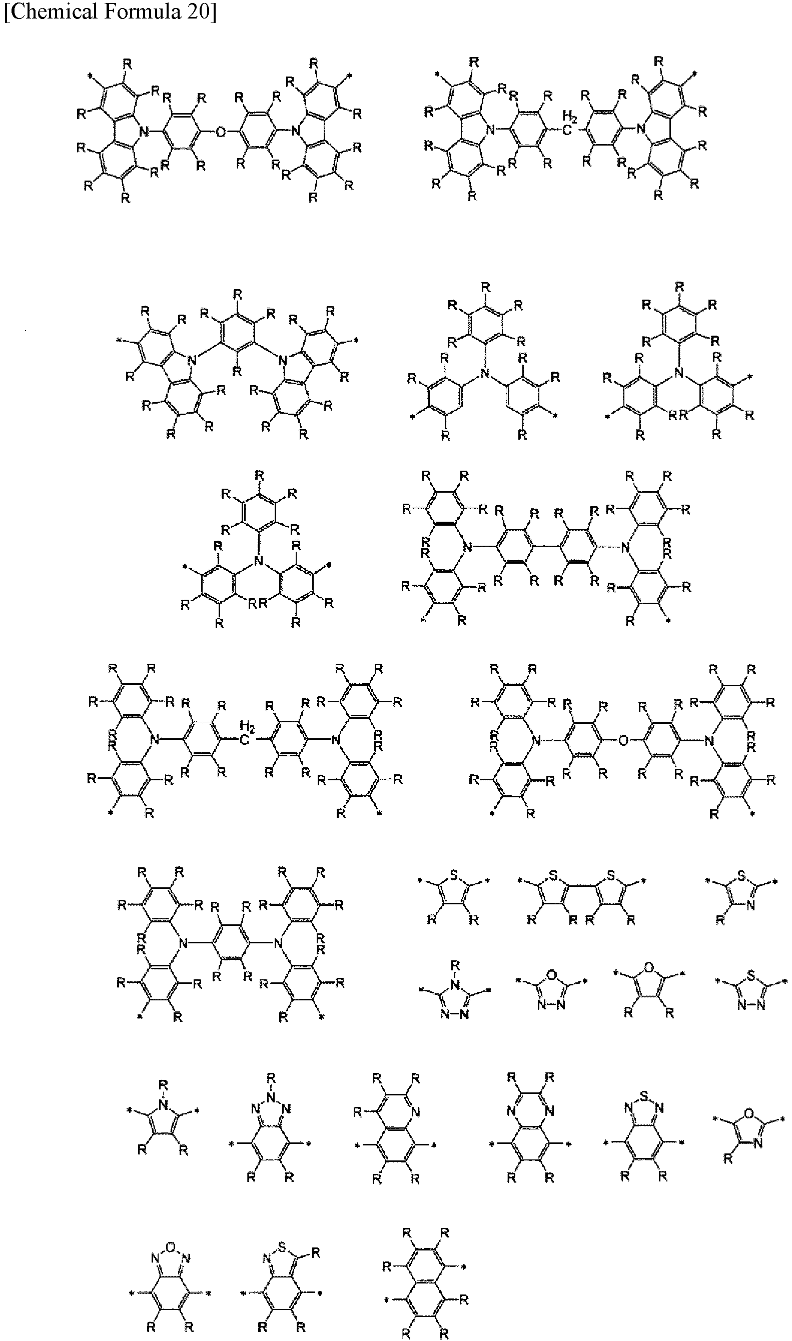

R each independently represents a hydrogen atom or a substituent. It is preferable that each R is independently selected from the group consisting of -R¹, -OR², -SR³, -OCOR⁴, -COOR⁵, -SiR⁶R⁷R⁸, a halogen atom, and a group including a polymerizable functional group described below. In one embodiment, R is more preferably -R¹. Each of R¹ to R⁸ independently represents a hydrogen atom, a linear, branched, or cyclic alkyl group of 1 to 22 carbon atoms, or an aryl group or heteroaryl group of 2 to 30 carbon atoms. An aryl group is an atomic group obtained by removing one hydrogen atom from an aromatic hydrocarbon. A heteroaryl group is an atomic group obtained by removing one hydrogen atom from an aromatic heterocycle. The alkyl group may be further substituted with an aryl group or heteroaryl group of 2 to 20 carbon atoms, and the aryl group or heteroaryl group may be further substituted with a linear, branched, or cyclic alkyl group of 1 to 22 carbon atoms.

Ar represents an arylene group or heteroarylene group of 2 to 30 carbon atoms. An arylene group is an atomic group obtained by removing two hydrogen atoms from an aromatic hydrocarbon. A heteroarylene group is an atomic group obtained by removing two hydrogen atoms from an aromatic heterocycle. Ar is preferably an arylene group, and more preferably a phenylene group.

Examples of the aromatic hydrocarbon include a monocyclic ring, a condensed ring, and a polycyclic ring where two or more rings selected from a monocyclic ring and a condensed ring are bonded together via a single bond. Examples of the aromatic heterocycle include a monocyclic ring, a condensed ring, and a polycyclic ring where two or more rings selected from a monocyclic ring and a condensed ring are bonded together via a single bond.

### (Structural Unit T)

The structural unit T is a monovalent structural unit that configures a terminal portion of a charge transport polymer. The structural unit T is not particularly limited, and is selected from, for example, a substituted or unsubstituted aromatic hydrocarbon structure, aromatic heterocyclic structure, and a structure including one or more of these structures. In one embodiment, from the viewpoint of imparting durability without reducing charge transport properties, the structural unit T is preferably a substituted or unsubstituted aromatic hydrocarbon structure, and more preferably a substituted or unsubstituted benzene structure. Except for the valence, the structural unit T may have the same structure as the structural unit L. In one embodiment, from the viewpoint of imparting durability without reducing charge transport properties, the structural unit T is preferably a substituted or unsubstituted aromatic hydrocarbon structure, and more preferably a substituted or unsubstituted benzene structure.

Specific examples of the structural unit T include the following. The structural unit T is not limited to the following.

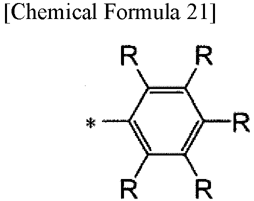

R each independently represents a hydrogen atom or a substituent. The substituent is selected from the group consisting of -R¹, -OR², -SR³, -OCOR⁴, -COOR⁵, -SiR⁶R⁷R⁸, a halogen atom, and a polymerizable functional group. R¹ to R⁸ are the same as R¹ to R⁸ in the structural unit L described above. In one embodiment, the substituent is preferably -R¹.

In one embodiment, the charge transport polymer preferably has a monovalent structural unit T1 represented by formula (c) below.

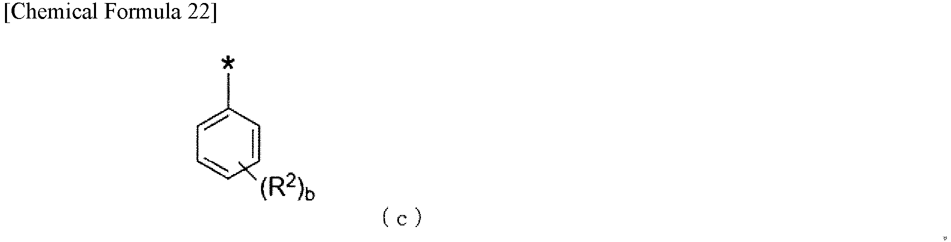

In the formula, R² is an alkyl group of 1 to 8 carbon atoms, and b is an integer from 1 to 5. In one embodiment, R² may preferably be an alkyl group of 1 to 7 carbon atoms, more preferably an alkyl group of 1 to 6 carbon atoms, and even more preferably an alkyl group of 1 to 5 carbon atoms. The alkyl group may have any one of a linear, branched, or cyclic structure. In one embodiment, b may preferably be 1 to 3, and more preferably 1 or 2.

### (Polymerizable Functional Group)

In one embodiment, a charge transport polymer may have a polymerizable functional group. Polymerizable functional groups are functional groups that can form bonds with each other when heat and/or light is applied. When a charge transport polymer includes a polymerizable functional group, an organic layer made from a cured film can be formed by curing a coating film formed using the charge transport polymer. Such an organic layer made from a cured film has solvent resistance necessary for laminating an upper layer on the organic layer through a wet process. Thus, when the charge transport polymer includes a polymerizable functional group, multilayering through a wet process becomes easy.

Examples of the polymerizable functional group include groups having a carbon-carbon multiple bond (such as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); cyclic thioether group such as episulfide groups; cyclic ester groups such as diketene groups and lactone groups; cyclic amide groups such as lactam groups), heterocyclic groups (for example, a furanyl group, pyrrolyl group, thiophenyl group and silolyl group); and benzocyclobutene groups.

The polymerizable functional group preferably includes at least one selected from the group consisting of a group having a carbon-carbon multiple bond, a group having a small ring, and a heterocyclic group, and more preferably includes at least one selected from the group consisting of a group having a carbon-carbon double bond, a cyclic ether group, and a heterocyclic group. Specifically, the polymerizable functional group is preferably a vinyl group, an acryloyl group, a methacryloyl group, an epoxy group, an oxetane group, a pyrrolyl group, or a thiophenyl group, and is more preferably a vinyl group, an oxetane group, or a thiophenyl group from the viewpoint of solubility and curability of the charge transport polymer. The polymerizable functional group may be a substituted or unsubstituted polymerizable functional group. Substituents which the polymerizable functional group can have include, for example, an alkyl group of 1 to 6 carbon atoms, such as a methyl group and an ethyl group. The polymerizable functional group may be bonded to an aromatic ring directly, or bonded to an aromatic ring via a divalent group, such as a linking group. Examples of the linking group include -O-, -(CH₂)ₙ-, and combinations thereof. Here, n may be an integer from 1 to 10.

In a charge transport polymer, a polymerizable functional group is preferably introduced into at least a terminal portion (i.e., structural unit T) of the charge transport polymer. A polymerizable functional group may be introduced into a portion other than the terminal portion (i.e., structural unit L or B), or may be introduced into both the terminal portion and the portion other than the terminal portion. It is preferable that a polymerizable functional group be introduced into only the terminal portion from the viewpoint of achieving both curability and charge transport properties. In a charge transport polymer having a branched structure, a polymerizable functional group may be introduced into a main chain, a side chain, or both the main chain and the side chain of the charge transport polymer.

For example, from the viewpoint of obtaining a sufficient change in solubility, the number of polymerizable functional groups per one molecule of a charge transport polymer is preferably two or more, and more preferably three or more. From the viewpoint of maintaining charge transport properties, the number of polymerizable functional groups is preferably 1,000 or less, and more preferably 500 or less.

From the viewpoint of obtaining favorable curability, the proportion of a polymerizable functional group in a charge transport polymer is preferably 0.1% by mole or more, more preferably 1% by mole or more, and even more preferably 3% by mole or more, relative to total of all the structural units. From the viewpoint of obtaining favorable charge transport properties, the proportion of the polymerizable functional group is preferably 70% by mole or less, more preferably 60% by mole or less, and even more preferably 50% by mole or less. Note that the "proportion of a polymerizable functional group" here means a proportion of a structural unit having a polymerizable functional group.

The content and proportion of a polymerizable functional group per one molecule of a charge transport polymer can be obtained as an average value by using an amount added (for example, an amount added of a monomer having a polymerizable functional group × the number of polymerizable functional groups per monomer) of a polymerizable functional group, an amount added of a monomer corresponding to each structural unit, a weight average molecular weight of the charge transport polymer, and the like, which were used to synthesize the charge transport polymer. The content of a polymerizable functional group can be calculated as an average value by using a ratio of an integral value of a signal derived from the polymerizable functional group to an integral value of the entire spectrum in a ¹H NMR (nuclear magnetic resonance) spectrum of a charge transport polymer, a weight average molecular weight of the charge transport polymer, or the like. For simplicity, when amounts added are clear, a value obtained using the amounts added is preferably employed.

### (Number Average Molecular Weight)

The number average molecular weight of a charge transport polymer can be adjusted appropriately in consideration of solubility in solvents, film formability, and the like. From the viewpoint of ensuring superior charge transport properties, the number average molecular weight is preferably 500 or more, more preferably 1,000 or more, even more preferably 2,000 or more, and still more preferably 5,000 or more. From the viewpoints of maintaining favorable solubility in solvents and facilitating preparation of ink compositions, the number average molecular weight is preferably 1,000,000 or less, more preferably 100,000 or less, even more preferably 50,000 or less, and still more preferably 30,000 or less. In one embodiment, the number average molecular weight may be within a range from 1,000 to 100,000, more preferably from 2,000 to 50,000, and even more preferably from 2,000 to 20,000.

### (Weight Average Molecular Weight)

The weight average molecular weight of a charge transport polymer can be adjusted appropriately in consideration of solubility in solvents, film formability, and the like. From the viewpoint of ensuring superior charge transport properties, the weight average molecular weight is preferably 1,000 or more, more preferably 5,000 or more, even more preferably 10,000 or more, and still more preferably 30,000 or more. From the viewpoints of maintaining favorable solubility in solvents and facilitating preparation of ink compositions, the weight average molecular weight is preferably 1,000,000 or less, more preferably 700,000 or less, even more preferably 400,000 or less, and still more preferably 200,000 or less and 100,000 or less in this order.

In one embodiment, the weight average molecular weight of a charge transport polymer may preferably be within a range from 2,000 to 500,000, more preferably from 3,000 to 100,000, and even more preferably from 8,000 to 50,000.

The number average molecular weight and the weight average molecular weight can be measured with gel permeation chromatography (GPC), using a calibration curve of standard polystyrenes.

### (Proportions of Structural Units)

From the viewpoint of improving durability of organic electronics elements, the proportion of the structural unit B included in a charge transport polymer is, relative to the total of all the structural units, preferably 1% by mole or more, more preferably 5% by mole or more, and even more preferably 10% by mole or more. From the viewpoint of controlling viscosity increase and achieving favorable synthesis of a charge transport polymer, or from the viewpoint of obtaining sufficient charge transport properties, the proportion of the structural unit B is preferably 50% by mole or less, more preferably 40% by mole or less, and even more preferably 30% by mole or less. Here, the above proportion of the structural unit B means the total amount of the structural units B1 and B2. In one embodiment, the structural unit B may include only the structural unit B1.

In a charge transport polymer, the proportion of the structural unit L is, relative to the total of all the structural units, preferably 10% by mole or more, more preferably 20% by mole or more, and even more preferably 30% by mole or more, from the viewpoint of obtaining sufficient charge transport properties. The proportion of the structural unit L is preferably 97% by mole or less, more preferably 92% by mole or less, and even more preferably 85% by mole or less, in consideration of the structural unit T and the structural unit B. Here, the proportion of the structural unit L means the total amount of the structural units L1 and L2. In one embodiment, the structural unit L may include only the structural unit L1.

From the viewpoint of solubility and curability, the proportion of the structural unit T included in a charge transport polymer is, relative to the total of all the structural units, preferably 3% by mole or more, more preferably 8% by mole or more, and even more preferably 15% by mole or more. The above ranges are also preferable from the viewpoint of improving properties of an organic electronics element, or from the viewpoint of controlling viscosity increase and achieving favorable synthesis of a charge transport polymer. From the viewpoint of obtaining sufficient charge transport properties, the proportion of the structural unit T is preferably 60% by mole or less, more preferably 55% by mole or less, and even more preferably 50% by mole or less.

In consideration of the balance of charge transport properties, durability, productivity, and the like, the ratio (molar ratio) of the structural unit L, the structural unit T, and the structural unit B is preferably L : T: B = 100 : (10 to 200) : (10 to 100), more preferably 100 : (20 to 180) : (20 to 90), and even more preferably 100 : (40 to 160) : (30 to 80).

The ratio of structural units can be determined from amounts added of monomers corresponding to the structural units used for synthesis of a charge transport polymer. The ratio of structural units can also be calculated as an average value using integral values of spectra derived from each structural unit in the ¹H-NMR spectrum of a charge transport polymer. For simplicity, when amounts added are clear, a value obtained using the amounts added is preferably employed. The ratio of the terminal group described above can also be obtained in the same manner.

From the viewpoint of stabilizing film quality of a coating film, the degree of polymerization (the number of structural units) of a charge transport polymer is preferably 5 or more, more preferably 10 or more, and even more preferably 20 or more. From the viewpoint of solubility in solvents, the degree of polymerization is preferably 1,000 or less, more preferably 700 or less, and even more preferably 500 or less. The degree of polymerization can be calculated as an average value using a weight average molecular weight of a charge transport polymer, a molecular weight of a structural unit, and a ratio of a structural unit.

The charge transport polymer according to the above embodiment may have a structure where multiple structural units B, and optionally structural units L2 and structural units T, are bonded via the structural unit L1, and the structural unit L1 causes a charge transport polymer including an N-Ph (phenyl) bond per molecule to be formed. The charge transport polymer including an N-Ph bond tends to be more easily doped and conjugated than, for example, a charge transport polymer including a Ph-Ph bond formed using a Suzuki-Miyaura coupling method. From this viewpoint, in one embodiment, the charge transport polymer preferably has a partial structure represented by formula (i) below.

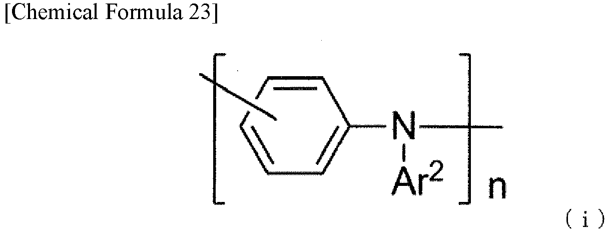

From the viewpoint that a partial structure represented by the above formula (i) can be easily introduced, the structural unit B1 and the structural unit L2 preferably include either a structure derived from a triphenylamine structure, or a structure derived from an N-phenylcarbazole structure.

In the above formula (i), n is an integer of 2 or more, and Ar² is as described above, preferably a structure represented by the above formula (b-1). In one embodiment, n is preferably an integer of 3 or more, more preferably an integer of 4 or more, and even more preferably an integer of 6 or more. Meanwhile, n is preferably an integer of 3,000 or less, more preferably an integer of 1,500 or less, and even more preferably an integer of 500 or less.

In the charge transport polymer, the content of an N-Ph bond formed by bonding between structural units may preferably be within a range from 10% to 80%, more preferably from 20% to 70%, and even more preferably from 30% to 60%. Here, the content is a value calculated from the amount added of a raw material monomer by performing NMR measurement, similar to the ratio of structural units.

### (Method of Manufacturing Charge Transport Polymer)

A charge transport polymer (I) having a structure represented by the above formula (I) can be prepared through a known method by using two or more types of aromatic compounds as raw material monomers, and reacting these raw material monomers. For example, it can be prepared by using an aromatic compound having a reactive functional group (1), and an aromatic compound having a reactive functional group (2) capable of reacting with the reactive functional group (1), and performing a coupling reaction according to a known method. Examples of combinations of the reactive functional group (1) and the reactive functional group (2) include a halogen atom and an amino group, a triflate group and an amino group, and a halogen atom and a boronic acid group. The triflate group (CF₃SO₂-) is also called a trifluoromethanesulfonyl group.

From the viewpoint that an N-Ph bond can be easily formed through the coupling reaction, the combination of the reactive functional groups (1) and (2) is preferably a halogen atom and an amino group, or a triflate group and an amino group. Here, the amino group is preferably a primary amino group.

In view of the above, the Buchwald-Hartwig reaction can be preferably applied to produce the charge transport polymer having the structure represented by the above formula (I). In the case of the Bucnwald-Hartwig reaction, the combination of the reactive functional groups (1) and (2) may be a halogen atom and an amino group. The amino group is preferably a primary amino group. More specifically, a polymer having a desired structure can be obtained by reacting an aromatic compound having a halogen atom directly bonded to an aromatic ring with an aromatic compound having a primary amino group. Here, the halogen atom may be a chlorine atom, a bromine atom, or an iodine atom. An aromatic compound having a triflate group may be used instead of the halogen atom.

In the above-described Buchwald-Hartwig reaction, an arylamine polymer having one or more structural units derived from each of the aromatic compounds (1) and (2) can be produced by using an aromatic compound (1) having two or more halogen atoms or triflate groups directly bonded to an aromatic ring, and an aromatic compound (2) having a primary amino group. From this point of view, a charge transport polymer having two or more desired structures (I) represented by formula (IA) below can be easily obtained by selecting an aromatic compound to be used as a raw material monomer.

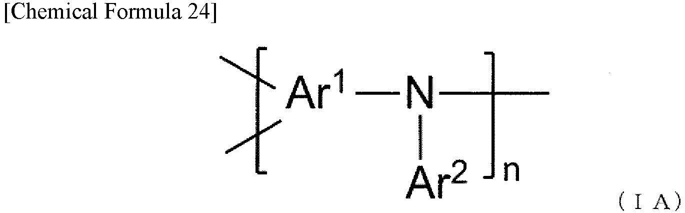

In the formula, Ar¹ and Ar² are as described above, and n is an integer of 2 or more. n may preferably be 3 or more, more preferably 5 or more, and even more preferably 10 or more. For example, n may be an integer appropriately set such that the weight average molecular weight (Mw) of the charge transport polymer is within a range of 1,000 or more and 500,000 or less, 2,000 or more and 500,000 or less, 3,000 or more and 500,000 or less, or 5,000 or more and 300,000 or less.

In one embodiment, as the raw material monomer for producing a charge transport polymer having the above structure (I), at least triphenylamine having a halogen atom directly bonded to an aromatic ring, and an aromatic primary amine (hereinafter also referred to as arylamine) having an electron-withdrawing group or an electron-donating group may be used. In this embodiment, the structure (I) in a charge transport polymer preferably includes a structure represented by formula (I - 1a) below.

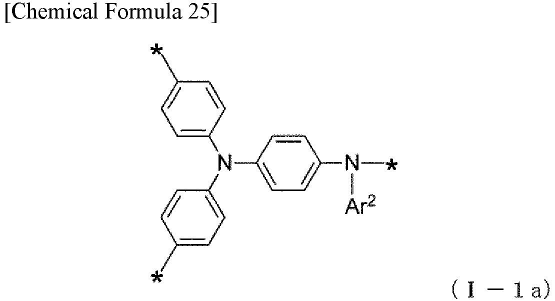

In the formula, Ar² represents a substituted or unsubstituted aryl group of 6 to 30 carbon atoms which has an electron-withdrawing group or an electron-donating group, as explained in detail above. "*" represents a bonding site with another structure.

More preferably, the structure (I) in a charge transport polymer includes a structure represented by formula (I-2a) or formula (I-3a) below, and even more preferably has a structure represented by formula (I-3a) below.

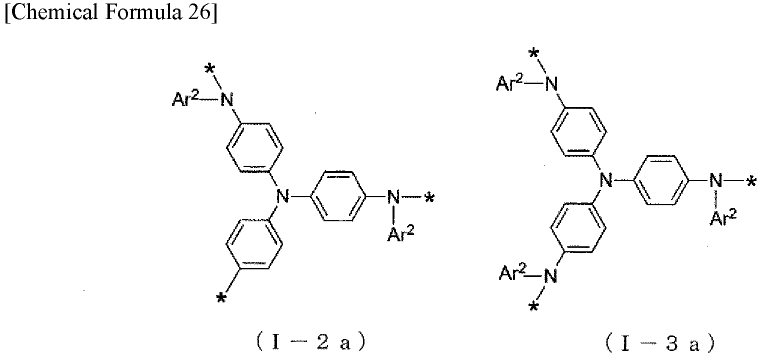

From the viewpoint of obtaining a charge transport polymer having a structure represented by the above formula (I-3a), in one embodiment, at least triphenylamine having three halogen atoms directly bonded to an aromatic ring, and arylamine can be preferably used as raw material monomers.

More specifically, a compound can be preferably used where, in the trivalent structural unit B1 represented by the above formula (a), Ar is a phenylene group, and a halogen atom is directly bonded to each of three bonding sites (*). An aromatic primary amine where hydrogen is bonded to two bonding sites (*) of the divalent structural unit L1 represented by the above formula (b), and which has one or more electron-withdrawing groups or electron-donating groups on an aromatic ring, can be preferably used.

In one embodiment, the charge transport polymer preferably further has the monovalent structural unit T represented by formula (c) below.

In the formula, R² and b are as described above. In order to introduce the structural unit T into a charge transport polymer, a compound where a halogen atom is directly bonded to a bonding site (*) in a structure represented by formula (c) below can be used as a raw material monomer.

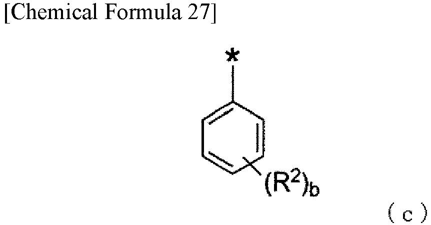

In one embodiment, the charge transport polymer (I) includes the structural units B1, L1 and T. In another embodiment, the charge transport polymer (I) may further include another structural unit in addition to the structural units B1, L1 and T. For example, the structural units B2 and L2 described above may further be included. In this case, an aromatic compound having a structure capable of inducing an additional structural unit and having a halogen atom directly bonded to an aromatic ring, or an aromatic compound having an amino group, can be used as a raw material monomer. Thus, by optionally combining raw material monomers, a charge transport polymer having a desired structure can be easily obtained.

For example, in one embodiment, in order to introduce the structural unit B2 and the structural unit L2 into a charge transport polymer, a compound where a halogen atom is directly bonded to a bonding site (*) in the structural unit B2 and the structural unit L2 can be used as a raw material monomer. In another embodiment, in order to introduce the structural unit L2, a compound having an -NH-Ar group at each bonding site (*) in the structural unit L2 can be used as a raw material monomer (in the formula, Ar independently represents an aryl group or heteroaryl group of 2 to 30 carbon atoms).

Hereinafter, a method of manufacturing a charge transport polymer using the Buchwald-Hartwig reaction will be described in more detail.

### (Buchwald-Hartwig Reaction)

The Buchwald-Hartwig reaction can be performed according to conditions and methods well known to those skilled in the art. For example, the reaction can be performed in an inert gas atmosphere, such as nitrogen, using a compound including a heavy metal, such as palladium, as a catalyst. During the reaction, a catalyst and a base are preferably used together.

In the Buchwald-Hartwig reaction, a palladium-containing catalyst can be preferably used as a catalyst. In the description, "palladium-containing catalyst" means a catalyst containing palladium and a ligand, and includes forms of a complex compound or salt containing palladium and a ligand, or a combination of a palladium-containing catalyst precursor, and a ligand or a ligand precursor.

The ligand preferably has a bulky structure, and specific examples include a phosphine ligand and a Buchwald ligand. N-heterocyclic carbene (NHC) can also be used as the ligand. Thereamong, a phosphine ligand such as tri-t-butylphosphine, tri-o-tolylphosphine, and triphenylphosphine are more preferable.

The palladium-containing catalyst may be a palladium(0) complex or a palladium(II) salt. Specific examples of the palladium-containing catalyst include bis(tri-t-butylphosphine)palladium(0), tetrakis(triphenylphosphine)palladium(0), bis[1,2-bis(diphenylphosphino)ethane] palladium(0), dichlorobis(triphenylphosphine)palladium(II), dichlorobis(tri-o-tolylphosphine)palladium(II), bis[di-t-butyl(4-dimethylaminophenyl)phosphine] dichloropalladium(II), [1,1'-bis(di-t-butylphosphino)ferrocene] dichloropalladium(II), dichloro[1,1'-bis(diphenylphosphino)ferrocene] palladium(II), dichloro[1,2-bis(diphenylphosphino)ethane] palladium(II), and dichloro[1,3-bis (diphenylphosphino)propane] palladium(II), Umicore CX31 and CX32 having NHC ligands. These compounds can also be used in combination with a ligand or a ligand precursor described above.

A precursor of a palladium-containing catalyst can also be used to generate active palladium from the precursor in a reaction system by means of components such as organometallic reagents, phosphines, and amines present in the system. Examples of the precursor include bis(dibenzylideneacetone)palladium(0), palladium(II) acetate, palladium(II) chloride, di-µ-chlorobis[(η-allyl)palladium(II)], dichlorobis(acetonitrile)palladium(II), and dichlorobis(benzonitrile)palladium(II).

When using the precursor of the palladium-containing catalyst described above, it is preferable to use a precursor of a ligand (ligand), such as a triphosphonium salt, together. A specific example of the triphosphonium salt is tri-t-butylphosphonium tetrafluoroborate. This compound produces tri-t-butylphosphine in a system, and functions as a ligand for palladium.

Although not particularly limited, in one embodiment, it is preferable to use bis(tri-t-butylphosphine)palladium(0), and tri-t-butylphosphonium tetrafluoroborate in combination as a palladium-containing catalyst.

In one embodiment, a palladium-containing catalyst having at least a structure represented by formula (1) below can be suitably used as a catalyst.

PdArBrP(t-Bu)₃ (1)

In the formula, Ar is a substituted or unsubstituted aryl group of 6 to 30 carbon atoms. Ar may be, for example, a substituted or unsubstituted phenyl group. At least one hydrogen atom in an aromatic ring of an aryl group may be substituted with an alkyl group of 1 to 12 carbon atoms.

A specific examples of the palladium-containing catalyst having the above structure is a compound represented by formula (2) below. This compound can be produced, for example, by reacting tris(dibenzylideneacetone)dipalladium(0), o-bromotoluene, and tri-tert-butylphosphine.

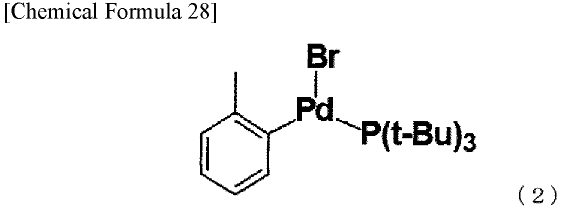

In another embodiment, a palladium-containing catalyst having at least a structure represented by formula (3) below can be suitably used as a catalyst.

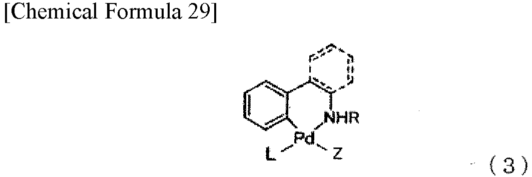

In the formula, R represents a hydrogen atom, or an alkyl group of 1 to 10 carbon atoms. L represents a ligand. Z represents a leaving group. The leaving group may be one selected from the group consisting of a halogen atom, a methylsulfonyloxy group (-OS₂CH₃), a tosyl group (-OSO₂C₆H₅CH₃), and a trifluoromethylsulfonyloxy group (-OSO₂CH₃).

A specific example of the catalyst having the structure represented by the above formula (3) is the following.

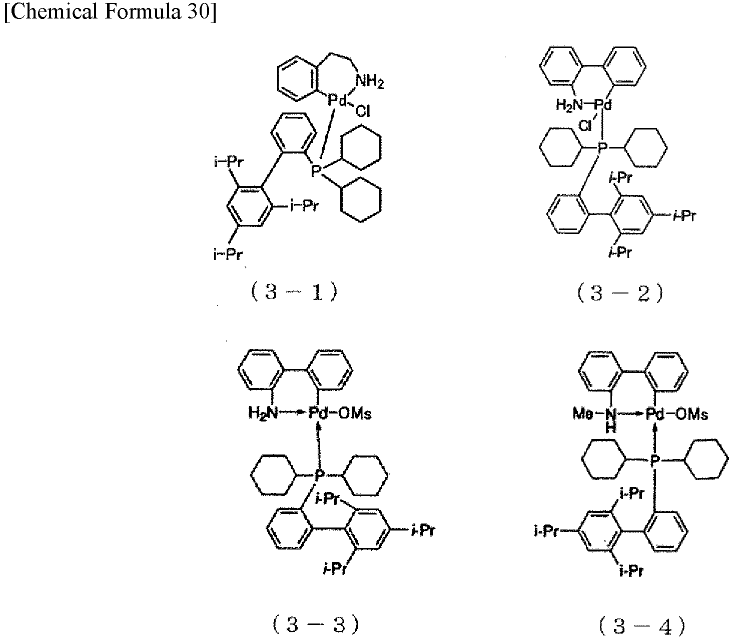

In one embodiment, a palladium-containing catalyst which can be suitably used can be manufactured according to methods well known to those skilled in the art, and can also be commercially available. For example, XphosPd series manufactured by Aldrich Chemical Company can be used, where catalysts represented by formulas (3-1) to (3-4) above are available as XphosPd G1, XphosPd G2, XphosPd G3, and XphosPd G4. In one embodiment, catalysts represented by formulas (3-2) and (3-4) above are more preferably used, which are available in turn as XphosPd G2 and XphosPd G4.

The amount used of a catalyst is not particularly limited, but may be typically within a range from 0.1% by mole or more to 20% by mole or less relative to an aromatic compound having an amino group, used as a raw material monomer. By adjusting the amount used of the catalyst within the above range, it is easy to proceed with the reaction efficiently and to control formation of by-products. In one embodiment, the amount used of catalyst is preferably within a range from 0.1% by mol to 10% by mole, more preferably from 0.1% by mol to 5% by mole, and even more preferably from 0.1% by mol to 2% by mol, relative to an aromatic compound having an amino group used as a raw material monomer. In the manufacturing method according to the present embodiment, it is possible to proceed with the reaction efficiently even when the amount used of a catalyst is reduced. Thus, it is easy to reduce the amount of impurities derived from the catalyst in a polymer obtained through the reaction.

In one embodiment, a palladium-containing catalyst may further include an additive. The additive is preferably a compound that functions as a ligand relative to a palladium metal. Specific examples of the compound, which can be used as the additive, include P(t-Bu)₃·HBF₃, and PC_{y3}·HBF₃, Xphos(2-dicyclohexylphosphino-2', 4', 6'-triisopropylbiphenyl). Particularly, P(t-Bu)₃·HBF₃ is preferable. When the additive is used, reactivity of the palladium catalyst tends to be further improved.

The base is not particularly limited, and may be either an inorganic base or an organic base. Although not particularly limited, in one embodiment, an organic base is preferable, and an organic alkali metal compound, such as sodium t-butoxy or n-butyllithium, can be suitably used. The amount used of the base is not particularly limited, but may be typically within a range from 1.0 mole equivalents or more to 4 mole equivalents or less relative to the mole number of an aromatic compound having an amino group used as a raw material monomer. By adjusting the amount used of the base within the above range, it is easy to proceed with the reaction efficiently and to control formation of by-products.

The reaction is preferably performed in the presence of an organic solvent. Examples of the organic solvent (reaction solvent) include aromatic hydrocarbons such as benzene and toluene, aliphatic ethers such as dioxane, tetrahydrofuran, and dimethoxyethane, amide-based solvents such as N,N-dimethylformamide and N,N-dimethylacetamide, and dimethyl sulfoxide. Particularly, in one embodiment, the reaction is preferably performed in the presence of an aromatic hydrocarbon, and more preferably in the presence of toluene.

A reaction temperature is not particularly limited. For example, the reaction temperature may be within a range from 0°C to 200°C. In one embodiment, the reaction temperature is preferably within a range from 80°C to 180°C.

In a mixture of raw material monomers, a blending ratio of an aromatic compound having an amino group, and an aromatic compound having a halogen atom is not particularly limited. However, if excessive unreacted raw material monomer remains in a reaction system, undesirable side reactions may occur, and thus the blending ratio is preferably adjusted appropriately. The blending ratio can be adjusted appropriately in consideration of the structures of the aromatic compounds used as raw material monomers, and the structure of a desired charge transport polymer.

In one embodiment, an aromatic compound below can be suitably used as a raw material monomer. Thus, in one embodiment, a raw material monomer may be a mixture of a halogenated aromatic compound having one or more halogen atoms and including an aromatic compound represented by formula (A) below, and an arylamine including an aromatic compound represented by formula (B) below. In the aromatic compound represented by formula (B) below, R¹ and a are as previously described in the description of formula (b-1). That is, R¹ is an electron-withdrawing group, an electron-donating group, or an alkyl group of 1 to 12 carbon atoms, a is an integer from 1 to 5, and at least one R¹ is an electron-withdrawing group or an electron-donating group. In one embodiment, R¹ is preferably an electron-withdrawing group.

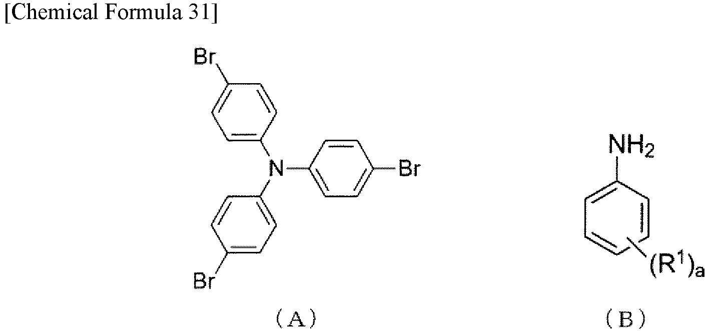

In another embodiment, the mixture preferably further includes an aromatic compound represented by formula (C) below, as a halogenated aromatic compound having one or more halogen atoms. In the aromatic compound represented by formula (C) below, R² and b are as previously described in formula (c).

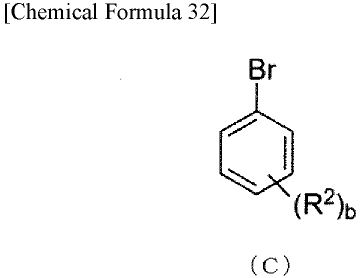

In one embodiment, an aromatic compound (A) represented by the above formula (A) and an aromatic compound (B) represented by the above formula (B) are preferably used as the raw material monomers. The blending ratio (A) : (B) of the raw material monomers is preferably (0.5 to 1.5) : 1.0, and more preferably (0.6 to 1.4) : 1.0, as a ratio of the number of reaction points based on amino groups of the aromatic compound (B).

In one embodiment, in addition to the aromatic compound (A) and the aromatic compound (B), an aromatic compound (C) represented by the above formula (C) is preferably used as a raw material monomer. The blending ratio (A) : (B) : (C) of the raw material monomers is preferably (0.2 to 0.9) : 1.0 : (0.0 to 1.0), more preferably (0.3 to 0.7) : 1.0 : (0.1 to 0.9), and even more preferably (0.4 to 0.6) : 1.0 : (0.2 to 0.8), as a ratio of the number of reaction points based on amino groups of the aromatic compound (B).

In one embodiment, in addition to structural units derived from the aromatic compounds (A), (B), and (C), a charge transport polymer may further include another structural unit. For example, it may further include a divalent structural unit L2 having a structure different from the divalent structural unit L1 derived from the aromatic compound (B). The structural unit L2 can be introduced using, for example, a compound represented by the formula below.

Q-L2-Q

Ar¹-NH-L2-NH-Ar¹

In the formula, Q represents a halogen atom and may be, for example, a chlorine atom, a bromine atom, or an iodine atom.

L2 represents an aromatic hydrocarbon or aromatic heterocycle of 2 to 30 carbon atoms, or a divalent organic group derived from triarylamine. In one embodiment, L2 is preferably a divalent organic group derived from triarylamine, and more preferably a divalent organic group derived from triphenylamine.

Ar¹ may be a monovalent organic group derived from an aromatic compound of 6 to 24 carbon atoms, and preferably has, for example, a structure represented by the above formula (b-1) described previously.

Although there are no particular limitations, from the viewpoint of easily producing a preferable charge transport polymer, in a method of manufacturing a charge transport polymer, it is preferable to use the aromatic compound (A), the aromatic compound (B), and the aromatic compound (C) as a raw material monomer. In one embodiment, the raw material monomer is preferably a mixture including only the aromatic compound (A), the aromatic compound (B), and the aromatic compound (C). When the mixture is used as the raw material monomer, it is possible to easily form a polymer having a structure of -(NAr-Ph)ₙ- (n is an integer of 2 or more) without forming a Ph-Ph bond in the molecule.

Although there are no particular limitations, in one embodiment, a charge transport polymer (I) may be a polymer obtained by reacting a monomer A1, a monomer B2, B3, B4, B5, or B6, and a monomer C1, which are used in examples describe below, in the presence of a catalyst.

As described above, the charge transport polymer having the structure of -(NAr-Ph)ₙ- can be easily synthesized according to the Buchwald-Hartwig reaction. Meanwhile, impurities derived from components such as a catalyst and a raw material monomer used in the reaction tend to remain in the polymer obtained through the reaction. Thus, it is preferable to perform separation and purification of the polymer after the above reaction. The separation and purification of the polymer can be performed by applying a method known in the art. For example, a method can be applied where water is added to and mixed with a reaction liquid after the coupling reaction, the mixed liquid is separated into an organic phase and an aqueous phase, and the polymer is collected from the organic phase.

In one embodiment, impurities derived from a catalyst and the like can be effectively removed by adding a heavy metal scavenger during the mixing of the reaction liquid and water. The heavy metal scavenger may be any compound capable of chelating and scavenging a heavy metal, such as palladium, used as a catalyst, or any compound capable of specifically bonding and adsorbing a heavy metal. For example, a dithiocarbamate may be used. In particular, an aqueous solution of an alkyl dithiocarbamate having an alkyl group of 1 to 6 carbon atoms may be suitably used. By appropriately selecting an organic solvent to be used at the time of separation and purification, the amount of impurities remaining in the polymer obtained through the above manufacturing method can be easily reduced. For example, a water-soluble organic solvent, such as methanol, may be suitably used at the time of mixing a reaction liquid with water.

When an organic electronics material including a charge transport polymer is configured, the charge transport polymer may include impurities mixed in the manufacturing process or the like. However, the amount of impurities is preferably as small as possible because the impurities contribute to deterioration of properties of an organic electronics element formed using the organic electronics material. In one embodiment, from the viewpoint of providing a charge transport polymer suitably usable as an organic electronics material, the palladium content in the polymer is preferably 100 ppm or less, more preferably 80 ppm or less, and even more preferably 50 ppm or less. The content (total amount) of halogen atoms in the polymer is preferably 300 ppm or less, more preferably 100 ppm or less, and even more preferably 60 ppm or less. As described above, by performing separation and purification as necessary after the coupling reaction, a charge transport polymer having a desired purity can be easily obtained.

An organic electronics material according to one embodiment of the present invention includes at least one charge transport polymer including the charge transport polymer (I) having the structure (I) described above. The content of the charge transport polymer (I) in an organic electronics material may preferably be 50% by mass or more, more preferably 70% by mass or more, and even more preferably 80% by mass or more, relative to the total mass of the organic electronics material. When the content of the charge transport polymer (I) is adjusted within the above ranges, excellent charge transport properties can be easily obtained. In one embodiment, the content of the charge transport polymer (I) may be 100% by mass.

In one embodiment, from the viewpoint of improving charge transport properties of an organic electronics material, an additive, such as a dopant, may be added. When an additive, such as a dopant, is used, the content of the charge transport polymer relative to the total mass of the organic electronics material may be 95% by mass or less, or may be 90% by mass or less.

The content of the dopant is, relative to the total mass of the organic electronics material, preferably 0.01% by mass or more, more preferably 0.1% by mass or more, and even more preferably 0.5% by mass or more. From the viewpoint of maintaining favorable film forming properties, the content of the dopant is, relative to the total mass of the organic electronics material, preferably 50% by mass or less, more preferably 30% by mass or less, and even more preferably 20% by mass or less.

From the viewpoint of applying a wet process as a film forming method, the organic electronics material preferably further includes a solvent. The organic electronics material may be configured as an ink composition (polymer solution) including a charge transport polymer and a solvent. The solvent to be used needs only to be capable of dissolving the charge transport polymer. By using the ink composition where the charge transport polymer is dissolved in the solvent, an organic layer can be easily formed using a simple method such as a wet process.

### (Solvent)

As the solvent, any solvent, such as water, an organic solvent, or a mixed solvent thereof can be used. Examples of the organic solvent include: alcohols such as methanol, ethanol, and isopropyl alcohol; alkanes such as pentane, hexane, and octane; cyclic alkanes such as cyclohexane; aromatic hydrocarbons such as benzene, toluene, xylene, mesitylene, tetralin, and diphenylmethane; aliphatic ethers such as ethylene glycol dimethyl ether, ethylene glycol diethyl ether, and propylene glycol-1-monomethyl ether acetate; aromatic ethers such as 1,2-dimethoxybenzene, 1,3-dimethoxybenzene, anisole, phenethol, 2-methoxytoluene, 3-methoxytoluene, 4-methoxytoluene, 3-phenoxytoluene, 2,3-dimethylanisole, and 2,4-dimethylanisole; aliphatic esters such as ethyl acetate, n-butyl acetate, ethyl lactate, and n-butyl lactate; aromatic esters such as phenyl acetate, phenyl propionate, methyl benzoate, ethyl benzoate, propyl benzoate, and n-butyl benzoate; amides such as N,N-dimethylformamide and N,N-dimethylacetamide; dimethyl sulfoxide, tetrahydrofuran, acetone, chloroform, and methylene chloride. Aromatic hydrocarbons, aliphatic esters, aromatic esters, aliphatic ethers, and aromatic ethers are preferable, and aromatic hydrocarbons are more preferable.

The content of the solvent in the organic electronics material (ink composition) can be determined in consideration of application to various coating methods. For example, the content of the solvent is preferably an amount such that the proportion of the charge transport polymer relative to the solvent is 0.1% by mass or more, more preferably 0.2% by mass or more, and even more preferably 0.5% by mass or more. The content of the solvent is preferably an amount such that the proportion of the charge transport polymer relative to the solvent is preferably 20% by mass or less, more preferably 15% by mass or less, and even more preferably 10% by mass or less.

In another embodiment, an organic electronics material may include an additive as an optional component from the viewpoint of improving workability in forming an organic layer as an ink composition and further improving function of the organic layer. Examples of the additive include a polymerization inhibitor, a stabilizer, a thickener, a gelling agent, a flame retardant, an antioxidant, a reduction inhibitor, an oxidizing agent, a reducing agent, a surface modifier, an emulsifier, an antifoaming agent, a dispersant, and a surfactant.

### <Organic Layer>

One embodiment relates to an organic layer formed using the above-described organic electronics material or the above-described ink composition. The organic layer exhibits favorable charge transport properties. By using the ink composition, the organic layer can be formed favorably and easily using a coating method. Examples of the coating method include conventional methods such as spin coating methods, casting methods, dipping methods, plate-based printing methods such as relief printing, intaglio printing, offset printing, lithographic printing, relief reversal offset printing, screen printing, and gravure printing, and plateless printing methods such as inkjet methods. When the organic layer is formed using the coating method, a coating layer obtained after coating may be dried through heat treatment to remove the solvent.

The heat treatment can be performed under the atmosphere or an inert gas atmosphere. Examples of the inert gas include helium gas, argon gas, nitrogen gas, and a mixed gas thereof. The "inert gas atmosphere" is an atmosphere where the concentration of the inert gas is, in volume ratio, preferably 99.5% or more, more preferably 99.9% or more, and even more preferably 99.99% or more by volume.

Heat treatment can be performed using a heater, such as a hot plate or an oven, for example. In order to perform heat treatment under an inert gas atmosphere, for example, a hot plate is used under an inert gas atmosphere, or an inert gas atmosphere is created inside an oven.

Heat treatment is preferably performed at a temperature equal to or higher than the boiling point of a solvent from the viewpoint of efficiently removing the solvent. When a polymerization reaction of a charge transport polymer is performed, a temperature where the polymerization reaction proceeds efficiently is preferable. In one embodiment, temperature of heat treatment is preferably 140°C or higher, more preferably 180°C or higher, and even more preferably 190°C or higher. From the viewpoint of controlling deterioration due to heat treatment, the temperature is preferably 300°C or lower, more preferably 280°C or lower, and even more preferably 250°C or lower.

From the viewpoint of improving efficiency of charge transport, thickness of the organic layer obtained after drying is preferably 0.1 nm or more, more preferably 1 nm or more, and even more preferably 3 nm or more. From the viewpoint of reducing electrical resistance, thickness of the organic layer is preferably 300 nm or less, more preferably 200 nm or less, and even more preferably 100 nm or less.

### <Organic electronics Element>

One embodiment relates to an organic electronics element having at least one organic layer described above. Examples of the organic electronics element include an organic EL element, an organic photoelectric conversion element, and an organic transistor. The organic electronics element preferably has a structure where an organic layer is disposed between at least a pair of electrodes. The organic electronics element can be manufactured using a manufacturing method including forming an organic layer using the organic electronics material or the ink composition.

### <Organic EL Element>

One embodiment relates to an organic EL element having at least one organic layer described above. The organic EL element typically includes a light emitting layer, an anode, a cathode, and a substrate, and optionally includes other functional layers such as a hole injection layer, an electron injection layer, a hole transport layer, and an electron transport layer. Each layer may be formed through a vapor deposition method, or a coating method. The organic EL element preferably includes the organic layer as a light emitting layer or another functional layer, more preferably as another functional layer, and even more preferably as at least one of a hole injection layer or a hole transport layer.

FIG. 1 is a cross-sectional schematic view illustrating an embodiment of an organic EL element. The organic EL element in FIG. 1 is an element with a multilayer structure, and has a substrate 8, an anode 2, a hole injection layer 3, a hole transport layer 6, a light emitting layer 1, an electron transport layer 7, an electron injection layer 5, and a cathode 4 provided in this order.

### [Light-Emitting Layer]

Examples of materials that can be used for the light emitting layer include small molecular weight compounds, polymers, and dendrimers. Polymers are preferably because they have high solubility in solvents and are suitable for coating methods. Examples of light emitting materials include fluorescent materials, phosphorescent materials, and thermally activated delayed fluorescent materials (TADF).

Specific examples of the fluorescent materials include small molecular weight compounds such as perylene, coumarin, rubrene, quinacridone, stilbene, color laser dyes, aluminum complexes, and derivatives of thereof; polymers such as polyfluorene, polyphenylene, polyphenylenevinylene, polyvinylcarbazole, fluorene-benzothiadiazole copolymers, fluorene-triphenylamine copolymers, and derivatives thereof; and mixtures thereof.

Examples of materials that can be used as the phosphorescent materials include metal complexes and the like including a metal such as Ir or Pt. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoquinoline)iridium) which emit red light. Specific examples of Pt complexes include PtOEP (2,3,7,8,12,13,17,18-octaethyl-21H,23H-forphine-platinum) which emits red light.

When the light emitting layer includes a phosphorescent material, a host material is preferably also included in addition to the phosphorescent material. As the host material, small molecular weight compounds, polymers, and dendrimers can be used. Examples of the small molecular weight compounds include CBP(4,4'-bis(9H-carbazol-9-yl)biphenyl), mCP(1,3-bis(9-carbazolyl)benzene), CDBP(4,4'-bis(carbazol-9-yl)-2,2'-dimethylbiphenyl), and derivatives thereof, whereas examples of the polymers include the above-described organic electronics materials, polyvinylcarbazole, polyphenylene, polyfluorene, and derivatives thereof.

Examples of thermally active delayed fluorescent materials include compounds such as PIC-TRZ(2-biphenyl-4,6-bis(12-phenylindolo[2,3-a]carbazol-11-yl)-1,3,5-triazine), Spiro-CN(2',7'-bis(diP-tolylamino)-9,9'-spirobifluorene-s,7-dicarbonitrile), CC2TA(2,4-bis{3-(9H-carbazol-9-yl)-9H-carbazol-9-yl}-6-phenyl-1,3,5-triazine), CZ-PS(9,9'-(4,4'-sulfonylbis(4,1-phenylene))bis(3,6-di-tert-butyl-9H-carbazole)), 4CzPN(3,4,5,6-tetra(9H-carbazol-9-yl)phthalonitrile), HAP-3TPA(4,4',4"-(1,3,3a¹,4,6,7,9-heptaazaphenalene-2,5,8-triyl)tris(N,N-bis(4-(tert-butyl)phenyl)aniline)), and 4CzIPN(1,2,3,5-tetrakis(carbazol-9-yl)-4,6-dicyanobenzene).

### [Hole injection layer and hole transport layer]

The organic layer is preferably used as at least one of a hole injection layer or a hole transport layer. As described above, these layers can be easily formed by using an ink composition including an organic electronics material and a solvent.

When the organic EL element has the organic layer as a hole injection layer and further has a hole transport layer, a known material can be used for the hole transport layer. When the organic EL element has the organic layer as a hole transport layer and further has a hole injection layer, a known material can be used for the hole injection layer. Both the hole injection layer and the hole transport layer may be the organic layer. Examples of the known material include aromatic amine-based compounds (aromatic diamines such as, for example, N,N'-di(naphthalene-1-yl)-N,N'-diphenyl-benzidine (α-NPD)), phthalocyanine-based compounds, and thiophene-based compounds (for example, thiophene-based conductive polymers such as poly(3,4-ethylenedioxythiophene):poly(4-styrenesulfonate) (PEDOT:PSS)).

When a hole transport layer is an organic layer having a changed solubility, a light emitting layer can be easily formed on the upper layer thereof through a wet process. In this case, a polymerization initiator may be included in the organic layer serving as the hole transport layer, or may be included in the organic layer underlying the hole transport layer.

### [Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene, perylene, and the like, carbodiimides, fluorenylidenemethane derivatives, anthraquinodimethane and anthrone derivatives, oxadiazole derivatives, thiadiazole derivatives, benzimidazole derivatives, quinoxaline derivatives, and aluminum complexes. The above-described organic electronics materials can also be used.

### [Cathode]

Examples of cathode materials used include metals or metal alloys, such as Li, Ca, Mg, Al, In, Cs, Ba, Mg/Ag, LiF, and CsF.

### [Anode]

Examples of anode materials used include metals (for example, Au) or other materials having conductivity. Examples of the other materials include oxides (for example, ITO: indium oxide/tin oxide), and conductive polymers (for example, polythiophene-polystyrene sulfonate mixtures (PEDOT:PSS)).

### [Substrate]

Glass, plastics, and the like can be used as the substrate. The substrate is preferably transparent and preferably has flexibility. Quartz glass, resin films, and the like can be preferably used.

The resin film is preferably a light-transmissive resin film. Examples of the resin film include films containing, as a main component, polyethylene terephthalate, polyethylene naphthalate, polyethersulfone, polyetherimide, polyetheretherketone, polyphenylene sulfide, polyarylate, polyimide, polycarbonate, cellulose triacetate, or cellulose acetate propionate.

When a resin film is used, an inorganic substance such as silicon oxide or silicon nitride may be coated onto the resin film to inhibit transmission of water vapor, oxygen, and the like.

### [Sealing]

The organic EL element may be sealed in order to reduce influence of outside air and to prolong lifetime. Examples of materials used for sealing include glass, epoxy resin, acrylic resin, plastic film such as polyethylene terephthalate and polyethylene naphthalate, and inorganic material such as silicon oxide or silicon nitride. However, there are no particular limitations on the material. A sealing method is also not particularly limited, and sealing may be performed using a known method.

### [Emission Color]

There are no particular limitations on emission color of organic EL elements. White organic EL elements are preferable as they can be used in various lighting applications such as residential lighting, automotive interior lighting, and backlights for watches or liquid crystal displays.

As a method for forming a white organic EL element, a method of using multiple light emitting materials to simultaneously emit multiple emission colors and mixing the colors can be used. There are no particular limitations on combinations of multiple emission colors, and examples include a combination including three maximum emission wavelengths of blue, green, and red, and a combination including two maximum emission wavelengths of blue and yellow, yellowish green and orange, or the like. Control of the emission color can be achieved by appropriate adjusting types and amounts of light emitting materials.

### <Display Element, Illumination Device, Display Device>

One embodiment relates to a display element including the organic EL element. For example, by using the organic EL element as an element corresponding to each pixel of red, green, and blue (RGB), a color display element can be obtained. Examples of image formation methods include a simple matrix where individual organic EL elements arrayed on a panel are directly driven by electrodes arranged in a matrix, and an active matrix type where a thin film transistor is arranged and driven on each element.

One embodiment relates to an illumination device including the organic EL element. One embodiment relates to a display device which includes an illumination device and a liquid crystal element as a display means. For example, the display device may be a display device using the illumination device as a backlight, and using a known liquid crystal element as a display means, that is, a liquid crystal display device.

### EXAMPLES

Hereinafter, the present invention will be described more specifically with reference to examples. However, the present invention is not limited to the examples described below, and includes various embodiments.

### <Synthesis of Charge Transport Polymers>

Raw material monomers used in the following examples and comparative examples are listed below.

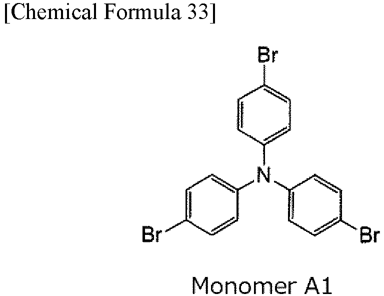

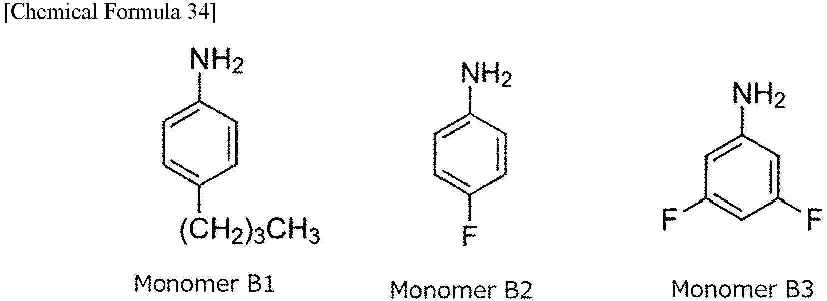

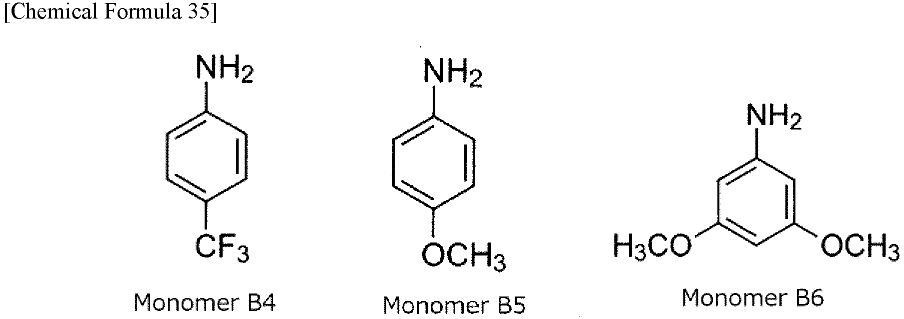

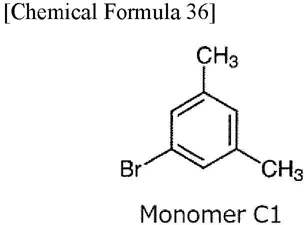

### (Example 1)

A Zimroth cooling tube and a reaction vessel equipped with a stirring function were prepared, and an oil bath was arranged so as to be freely movable back and forth relative to the reaction vessel. The following components were each charged into the reaction vessel, which was nitrogen-substituted, while injecting nitrogen, and a nitrogen gas supply device was connected to the tip of the Zimroth cooling tube to provide a nitrogen atmosphere reaction environment.
Raw material monomers: monomer A1 (1285 mg, 2.67 mmol), monomer B2 (556 mg, 5.00 mmol), and monomer C1 (370 mg, 2.00 mmol)
Organic solvent (toluene): dehydrated toluene stored under a nitrogen atmosphere, manufactured by FUJIFILM Wako Pure Chemical Corporation, 25.6 mL
Base: sodium t-butoxy, manufactured by Tokyo Chemical Industry Co., Ltd., 1,442 mg (3.0 equivalents based on monomer B2 having an amino group)
Catalyst: Xphos Pd G2 (Chloro(2-dicyclohexylphosphino-2',4',6'-triisopropyl-1,1'-biphenyl) [2-(2'-amino-1,1'-biphenyl)]palladium), manufactured by FUJIFILM Wako Pure Chemical Corporation, 20 mg (0.5% by mole based on monomer B2 having an amino group)
Next, the mixture was heated in an oil bath (bath temperature: 120°C) to a temperature at which the organic solvent in the reaction vessel was refluxed, and the reaction was performed for two hours while stirring.

After the above reaction, the temperature of the reaction mixture in the reaction vessel was lowered to room temperature, and 10 mL of an aqueous solution of sodium N,N-diethyldithiocarbamate trihydrate (manufactured by FUJIFILM Wako Pure Chemical Corporation) adjusted to 0.1 mol/L was added and stirred. Methanol-water (9:1) was added to the obtained suspension solution, reprecipitation was performed, and the resulting precipitate was subjected to suction filtration.

Ethyl acetate was added to the obtained precipitate, the mixture was stirred for 15 minutes while being heated in an oil bath at 60°C, and the precipitate was washed with ethyl acetate. Subsequently, the washed precipitate was collected through suction filtration. Using the collected washed precipitate, washing with ethyl acetate was once more performed in the same manner as described above to remove residual monomers and reaction products soluble in ethyl acetate from the precipitate. Subsequently, the precipitate washed with ethyl acetate was dried under reduced pressure to obtain a polymer (light yellow powder).

By measuring proton nuclear magnetic resonance (¹H-NMR) spectrum of the polymer, it was confirmed that the polymer had a structure obtained by polycondensation of monomer A1, monomer B1, and monomer C1. The yield of the polymer was 55%, the weight average molecular weight (Mw) was 13,300, the number average molecular weight (Mn) was 7,300, and the molecular weight distribution Mw/Mn was 1.8.

Note that the ¹H-NMR spectrum was measured using an AVANCE-600NMR spectrometer of Bruker Corporation. Mw and Mn were measured using a Prominence GPC system manufactured by SHIMADZU CORPORATION. In the measurement of Mw and Mn, according to the gel permeation chromatography (GPC) method, a styrene gel column was used, calibration was performed with standard polystyrene at 40°C, and tetrahydrofuran was used as an eluent. Measurement conditions were as follows. These are also the same in examples describe below.

Liquid feeding pump: L-6050 Hitachi High-Technologies Corporation
UV-Vis detector: L-3000 Hitachi High-Technologies Corporation
Column: Gelpack (registered trademark) GL-A160S/GL-A150S Resonac Corporation
Eluent: THF (for HPLC, does not contain stabilizers) Wako Pure Chemical Corporation
Flow Rate: 1 ml/min
Column temperature: room temperature
Molecular weight standard: standard polystyrene

### (Examples 2 to 5)

Polymers were prepared in the same manner as in example 1 except that the raw material monomer, the blending amount, and the catalyst were changed as listed in Table 1. Various measurements were performed on the obtained polymers in the same manner as in example 1. The results are listed in Table 1.

### (Control Example 1)

A polymer was prepared in the same manner as in example 1 except that the raw material monomer, the blending amount, and the catalyst were changed as listed in Table 1. Various measurements were performed on the obtained polymer in the same manner as in example 1. The result is listed in Table 1.

### [Table 1]

**Table 1**

| Item | Trifunctional | Difunctional | Monofunctional | Blending amount mg(mmol) | | | Catalyst | | | Base | | |
|---|---|---|---|---|---|---|---|---|---|---|---|---|
| | A | B | C | A | B | C | Product name | Amount added mg | Amount added mol% | Product name | Amount added mg | Amount added equivalents |
| Example 1 | A1 | B2 | C1 | 1285(2.67) | 556 (5.00) | 370(2.00) | Xphos Pd G2 | 20 | 0.5 | tert-BuONa | 1442 | 3.0 (15mmol) |
| Example 2 | A1 | B3 | C1 | 1285(2.67) | 646 (5.00) | 370(2.00) | Xphos Pd G2 | 20 | 0.5 | tert-BuONa | 1442 | 3.0 (15mmol) |
| Example 3 | A1 | B4 | C1 | 1285(2.67) | 806 (5.00) | 370(2.00) | Xphos Pd G2 | 20 | 0.5 | tert-BuONa | 1442 | 3.0 (15mmol) |
| Example 4 | A1 | B5 | C1 | 1285(2.67) | 616(5.00) | 370(2.00) | Xphos Pd G2 | 20 | 0.5 | tert-BuONa | 1442 | 3.0 (15mmol) |
| Example 5 | A1 | B6 | C1 | 1285(2.67) | 766(5.00) | 370(2.00) | Xphos Pd G2 | 20 | 0.5 | tert-BuONa | 1442 | 3.0(15mmol) |
| Control example 1 | A1 | B1 | C1 | 1285(2.67) | 746 (5.00) | 370(2.00) | Xphos Pd G2 | 20 | 0.5 | tert-BuONa | 1442 | 3.0 (15mmol) |

| Item | Trifunctional | Difunctional | Monofunctional | Solvent | | Reaction temperature °C | N.V./wt% (synthesis concentration) | Yield wt% | Molecular weight | |
|---|---|---|---|---|---|---|---|---|---|---|
| | A | B | C | Product name | Amount added mL | | | | Mw | Mn |
| Example 1 | A1 | B2 | C1 | toluene | 25.6 | 120 | 10.0 | 55 | 13,300 | 7,300 |
| Example 2 | A1 | B3 | C1 | toluene | 26.6 | 120 | 10.0 | 54 | 47,300 | 15,100 |
| Example 3 | A1 | B4 | C1 | toluene | 28.5 | 120 | 10.0 | 23 | 8,300 | 2,700 |
| Example 4 | A1 | B5 | C1 | toluene | 26.3 | 120 | 10.0 | 63 | 20,200 | 3,900 |
| Example 5 | A1 | B6 | C1 | toluene | 28.0 | 120 | 10.0 | 63 | 39,800 | 6,100 |
| Control example 1 | A1 | B1 | C1 | toluene | 27.8 | 120 | 10.0 | 58 | 33,300 | 12,500 |

### Evaluation of Charge Transport polymer

### (Evaluation of HOMO Level)

Using each charge transport polymer obtained in examples 1 to 5 and control example 1, an ink composition was prepared according to a method described below. Furthermore, an organic layer was formed using the ink composition, and a HOMO level was evaluated.

The polymer (50.0 mg) and the following ionic compound (1) (0.5 mg) were weighed into a 9 mL screw tube, and toluene (4,949.5 mg) was added and dissolved to prepare an ink composition.

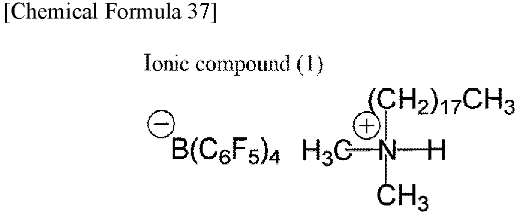

Then, the ink composition was filtered using a PTFE filter (pore size 0.2 µm). The filtered ink composition was dropped onto a quartz substrate (length 22 mm × width 29 mm × thickness 0.7 mm), and formed into a film using a spin coater. Subsequently, the film was heated at 210°C for 30 minutes in the atmosphere to form an organic layer with a film thickness of 30 nm on the quartz substrate.

A surface work function of the organic layer previously formed on the quartz substrate was measured in the atmosphere using a photoelectron yield spectrometer (model AC-5) manufactured by RIKEN KEIKI Co., Ltd. HOMO levels determined from surface work function values are listed in Table 2.

### [Table 2]

**Table 2**

| Item | HOMO level /eV |
|---|---|
| Example 1 | 5.25~5.30 |
| Example 2 | 5.35~5.40 |
| Example 3 | 5.45~5.50 |
| Example 4 | 5.00~5.05 |
| Example 5 | 4.95~5.00 |
| Control example 1 | 5.10~5.15 |

As listed in Table 2, in the charge transport polymer according to the present invention (examples 1 to 5), it is obvious that by having an electron-withdrawing group or an electron-donating group, the HOMO level of the charge transport polymer without these substituents (control example 1) can be easily adjusted. In particular, in the case of having an electron-withdrawing group (examples 1 to 3), it is obvious that a higher HOMO level can be easily obtained.

When the HOMO level is made deeper, the energy level difference between the charge transport polymer, and an adjacent hole transport layer or light emitting layer becomes small, which is preferable from the viewpoint of lower driving voltage and improved conductivity. Therefore, by introducing an electron-withdrawing group or electron-donating group at a specific position of a charge transport polymer, it is easy to improve properties such as conductivity and driving voltage of an organic EL element.

From the above, it is obvious that according to the present invention, it is possible to provide an organic electronics material including a charge transport polymer which can easily form an organic layer capable of improving properties such as conductivity.

### DESCRIPTION OF THE REFERENCE SIGNS

- 1: Light emitting layer
- 2: Anode
- 3: Hole injection layer
- 4: Cathode
- 5: Electron injection layer
- 6: Hole transport layer
- 7: Electron transport layer
- 8: Substrate

## Claims

1. An organic electronics material comprising:
a charge transport polymer having a branched structure wherein
the charge transport polymer includes:
a trivalent structural unit represented by formula (a) below; and a divalent structural unit represented by formula (b) below,
the charge transport polymer includes a structure which is represented by formula (I) and is formed through direct bonding of at least one bonding site in the trivalent structural unit and at least one bonding site in the divalent structural unit, and
the charge transport polymer has a weight average molecular weight of 2,000 to 500,000 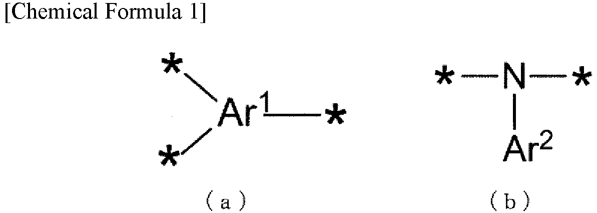 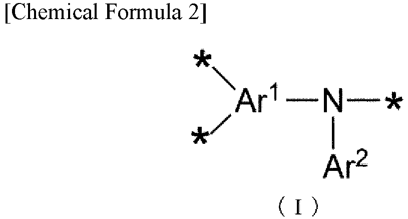
where Ar¹ represents a trivalent organic group derived from an aromatic hydrocarbon or aromatic heterocycle of 2 to 30 carbon atoms, or triarylamine, Ar² represents a monovalent organic group derived from an aromatic hydrocarbon of 6 to 30 carbon atoms which has an electron-withdrawing group or an electron-donating group, and * represents a bonding site with another structure.

2. The organic electronics material according to claim 1, wherein the structure represented by the formula (I) includes a structure represented by formula (I-1) below or formula (I-2) below 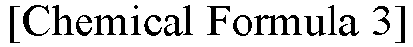 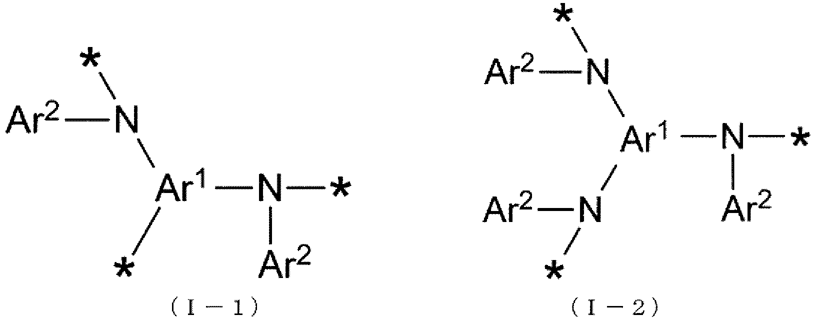 where Ar¹ represents a trivalent organic group derived from an aromatic hydrocarbon or aromatic heterocycle of 2 to 30 carbon atoms, or triarylamine, Ar² represents a monovalent organic group derived from an aromatic hydrocarbon of 6 to 30 carbon atoms which has an electron-withdrawing group or an electron-donating group, and * represents a bonding site with another structure.

3. The organic electronics material according to claim 1 or 2, wherein in the formula (I), Ar¹ has a structure derived from triphenylamine or a structure derived from N-phenylcarbazole.

4. The organic electronics material according to any one of claims 1 to 3, wherein in the formula (I), Ar² has a structure represented by formula (b-1) below 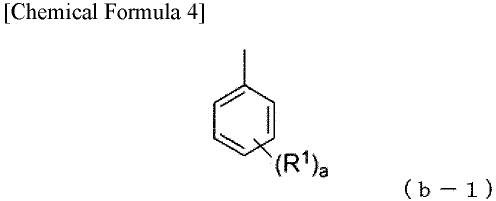 where R' is an electron-withdrawing group, an electron-donating group, or an alkyl group of 1 to 12 carbon atoms, at least one R¹ is an electron-withdrawing group or an electron-donating group, and a is an integer from 0 to 5.

5. The organic electronics material according to claim 4, wherein in the formula (b-1), R¹ is an electron-withdrawing group, a is an integer equal to 1 or 2, and the electron-withdrawing group is at least one selected from the group consisting of a halogen group, a halogen-substituted alkyl group, a nitro group, a cyano group, a sulfonic acid group, and a sulfoxide group.

6. The organic electronics material according to any one of claims 1 to 5, wherein the charge transport polymer further includes a monovalent structural unit represented by formula (c) below, 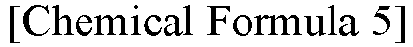 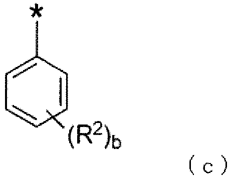 wherein R² is an alkyl group of 1 to 8 carbon atoms, and b is an integer from 1 to 5.

7. The organic electronics material according to any one of claims 1 to 6, further comprising: a solvent.

8. An organic layer formed using the organic electronics material according to any one of claims 1 to 7.

9. An organic electronics element comprising: the organic layer according to claim 8.

10. An organic electroluminescence element comprising: the organic layer according to claim 8.
